# EUROPEAN PATENT APPLICATION

(11) **EP 4 780 163 A1**
(43) Date of publication of application: **22.07.2026**
(21) Application number: 25206406.8
(22) Date of filing: 02.10.2025
(51) Int. Cl.: H10D 62/13, H10D 30/01, H10D 30/43, H10D 30/00, H10D 30/69, H10D 84/01, H10D 84/85, H10D 88/00

(54) **SEMICONDUCTOR DEVICE**

(30) Priority: 21.01.2025 KR 20250009032
(71) Applicant: Samsung Electronics Co., Ltd., Suwon-si, Gyeonggi-do 16677 (KR)
(72) Inventor: HWANG, Kyuman, Suwon-si (KR); PARK, Sungil, Suwon-si (KR); PARK, Jae Hyun, Suwon-si (KR); PARK, Juhun, Suwon-si (KR); HAN, Sangwoo, Suwon-si (KR)
(74) Representative: Marks & Clerk LLP

(57) **Abstract**

A semiconductor device includes: a substrate; multiple lower channel patterns positioned on the substrate; multiple upper channel patterns positioned on the plurality of lower channel patterns; a lower gate electrode surrounding the plurality of lower channel patterns; an upper gate electrode surrounding the plurality of upper channel patterns; a lower source/drain pattern positioned on opposite sides of the plurality of lower channel patterns, an upper source/drain pattern positioned on the lower source/drain pattern and on opposite sides of the plurality of upper channel patterns, and a barrier structure including a first barrier pattern positioned on the plurality of lower channel patterns and having a different conductivity type from the lower source/drain pattern, and a second barrier pattern positioned between the first barrier pattern and the plurality of upper channel patterns and having a different conductivity type from the upper source/drain pattern.

## Description

### BACKGROUND

A semiconductor is a material that belongs to the intermediate region between conductors and insulators, and is a material that conducts electricity under certain conditions. Using these semiconductor materials, various semiconductor devices may be manufactured, such as memory devices. These semiconductor devices may be used in a variety of electronic devices. As the electronics industry develops, the demands on the characteristics of semiconductor devices have also increased. For example, there is an increasing demand for high reliability, high speed, and/or multi-functionality in semiconductor devices. To meet these demands, structures within semiconductor devices are becoming increasingly complex and integrated.

### SUMMARY

Implementations of the present disclosure provide a semiconductor device with stable electric characteristics and improved reliability.

According to an some implementations, a semiconductor device comprises: a substrate; a plurality of lower channel patterns on the substrate; a plurality of upper channel patterns on the plurality of lower channel patterns; a lower gate electrode between adjacent lower channel patterns of the plurality of lower channel patterns and above and below the plurality of lower channel patterns; an upper gate electrode between adjacent upper channel patterns of the plurality of upper channel patterns and above and below the plurality of upper channel patterns; a lower source/drain pattern on opposite sides, along a first direction, of each lower channel pattern of the plurality of lower channel patterns, an upper source/drain pattern on the lower source/drain pattern and on opposite sides, along the first direction, of each upper channel pattern of the plurality of upper channel patterns, and a barrier structure including a first barrier pattern on the plurality of lower channel patterns, the first barrier pattern having a conductivity type that is different from a conductivity type of the lower source/drain pattern, and a second barrier pattern between the first barrier pattern and the plurality of upper channel patterns, the second barrier pattern having a conductivity type that is different from a conductivity type of the upper source/drain pattern.

According to some implementations, a semiconductor device comprises: a substrate; a plurality of lower channel patterns on the substrate; a lower gate electrode between adjacent lower channel patterns of the plurality of lower channel patterns and above and below the plurality of lower channel patterns; a lower source/drain pattern on opposite sides, along a first direction, of each lower channel pattern of the plurality of lower channel patterns, the lower source/drain pattern having a first conductivity type; and a barrier structure on the lower gate electrode, the barrier structure includes a first barrier pattern overlapping the lower source/drain pattern, first barrier pattern having a second conductivity type that is different from the first conductivity type; and a second barrier pattern on the first barrier pattern, the second barrier pattern having the first conductivity type.

According to some implementations, a semiconductor device comprises: a substrate; a plurality of lower channel patterns on the substrate; a plurality of upper channel patterns on a plurality of lower channel patterns; a lower gate electrode between adjacent lower channel patterns of the plurality of lower channel patterns and above and below the plurality of lower channel patterns; an upper gate electrode between adjacent upper channel patterns of the plurality of upper channel patterns and above and below the plurality of upper channel patterns; a lower source/drain pattern on opposite sides, along a first direction, of each lower channel pattern of the plurality of lower channel patterns; an upper source/drain pattern on the lower source/drain pattern and on opposite sides, along the first direction, of each upper channel pattern of the plurality of upper channel patterns; and a barrier structure on the plurality of lower channel patterns and including a same material as the plurality of lower channel patterns, the barrier structure includes a first barrier pattern on the lower gate electrode, wherien the first barrier pattern has a conductivity type that is different from a conductivity type of the lower source/drain pattern; and a second barrier pattern between the first barrier pattern and the upper gate electrode, wherein the second barrier pattern has a conductivity type that is different from a conductivity type of the upper source/drain pattern, where a distance between a lower surface of the first barrier pattern and an upper surface of the substrate along a second direction intersecting to the first direction, is less than a distance between an upper surface of the lower source/drain pattern and the upper surface of the substrate along the second direction.

According to some implementations, a method for manufacturing a semiconductor device comprises the steps of forming a substrate, a lower pattern structure including lower sacrificial layers and lower active patterns alternately stacked on the substrate, a preliminary barrier structure positioned on the lower pattern structure, and an upper pattern structure including upper sacrificial layers and upper active patterns alternately stacked on the preliminary barrier structure, performing an implant process to form a barrier structure including a first barrier pattern having a first conductivity type in the preliminary barrier structure and a second barrier pattern positioned on the first barrier pattern and having a second conductivity type different from the first conductivity type, forming a sacrificial gate electrode on the upper pattern structure, patterning the upper pattern structure using the sacrificial gate electrode as a mask to form an upper source/drain recess, patterning the barrier structure and the lower pattern structure using the sacrificial gate electrode as a mask to form a lower source/drain recess, forming a lower source/drain pattern in the lower source/drain recess and forming an upper source/drain pattern having the first conductivity type in the upper source/drain recess, and the step of removing the sacrificial gate electrode, the upper sacrificial layer and the lower sacrificial layer, and forming a lower gate electrode, an upper gate electrode, and a main gate electrode.

A doping concentration of the first barrier pattern may be less than or equal to a doping concentration of the lower source/drain pattern.

A doping concentration of the second barrier pattern may be less than or equal to a doping concentration of the upper source/drain pattern.

The barrier structure may comprise the same material as the substrate.

The barrier structure and the substrate may include silicon.

At least a portion of the first barrier pattern may overlap the lower source/drain electrode. For instance, at least a portion of the first barrier pattern may overlap the lower source/drain electrode in the first direction.

At least a portion of the second barrier pattern may overlap the upper source/drain pattern. At least a portion of the second barrier pattern may overlap the upper source/drain pattern in the first direction.

A distance between the lower surface of the first barrier pattern and the upper surface of the substrate may be less than a distance between the upper surface of the lower source/drain pattern and the upper surface of the substrate.

The lower source/drain pattern includes a first lower source/drain layer positioned on the substrate, and a second lower source/drain layer positioned on the first lower source/drain layer, wherein at least a portion of a side surface of the first barrier pattern may be in contact with the first lower source/drain layer.

The step of forming the barrier structure may include a step of performing an implant process on a lower portion of the preliminary barrier structure to form a first barrier pattern having the first conductive type, and a step of performing an implant process on an upper portion of the preliminary barrier structure to form a second barrier pattern having the second conductive type.

In the step of forming the barrier structure, at least a portion of the lower sacrificial layer may be doped with an impurity of the first conductivity type.

In the step of forming the barrier structure, at least a portion of the upper sacrificial layer may be doped with an impurity of the second conductive type.

According to some implementations, the reliability of semiconductor devices may be improved.

At least some of the above and other features of the invention are set out in the claims.

### BRIEF DESCRIPTION OF THE DRAWINGS

FIG. 1 is a plan view showing an example of a semiconductor device according to some implementations.
FIG. 2 is a cross-sectional view showing A-A' of FIG. 1.
FIG. 3 is a cross-sectional view showing B-B' of FIG. 1.
FIG. 4 is a cross-sectional view showing C-C' of FIG. 1.
FIG. 5 is an enlarged cross-sectional view of the S1 area of FIG. 2.
FIGS. 6, 7, 8, 9, 10, 11, 12, 13, 14, and 15 are cross-sectional views corresponding to area S1 of FIG. 2.
FIG. 16 is a cross-sectional view corresponding to B-B' of FIG. 1.
FIGS. 17, 18, 19, 20, 21, 22, 23, 24, 25, 26, 27, 28, 29, and 30 are cross-sectional views showing intermediate stages of an example of a method for manufacturing a semiconductor device according to some implementations.
FIGS. 31, 32, 33, 34, and 35 are cross-sectional views showing intermediate steps in an example of a method of manufacturing a semiconductor device according to some implementations.

### DETAILED DESCRIPTION

Hereinafter, various implementations are described in detail with reference to the drawings The techniques discussed herein may be embodied in many different forms and is not limited to the embodiments described herein.

To clearly explain the present invention, the same reference numerals are used for identical or similar components throughout the specification.

In some instances, the size and the thickness of each component shown in the drawing may be arbitrarily shown for convenience of explanation and the techniques discussed herein are not necessarily limited to what is shown. In some instances, to clearly represent the various layers and areas in the drawing, the thickness shown in the drawings may be enlarged or exaggerated

It is noted that, when a part, such as a layer, membrane, region, or plate, is "over" or "on" another part, this includes not only cases where it is "directly over" the other part, but also cases where there are other parts in between. Conversely, when a part is "directly above" another part, there is no other part in between. Also, being "above" or "on" a reference part means being located above or below the reference part, and does not necessarily mean being located "above" or "on" the opposite direction of gravity.

Additionally, throughout the specification, whenever a part is said to "include" a component, this does not mean that it excludes other components, but rather that it may include other components, unless otherwise specifically stated.

Additionally, throughout the specification, the term viewing "in plan", refers to viewing the target portion from above, and the term "in cross section", refers to viewing the target portion from the side in a cross-section cut vertically.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

For a semiconductor device according to some implementations, the device may be formed of a GAA (Gate All Around) structure, a 3DSFET (3D Stack Field Effect Transistor) structure, etc., in which four side surfaces of the channel are surrounded by gate electrodes. However, example implementations are not limited thereto, and the transistor may be formed with a FinFET (Fin Field Effect Transistor) structure, an MBCFET^{™} (Multi Bridge Channel Field Effect Transistor) structure, a CFET (Complementary Field Effect Transistor) structure, etc.

The term "overlap" (or "overlapping", or like terms) in a particular direction, as may be used herein, is intended to broadly refer to two elements that are arranged such that a line that runs parallel to the particular direction can be placed that intersects with at least a portion of each element. The term "overlap" does not require that the first and second elements be completely aligned with one another. That is, components or layers described with reference to "overlap" in a particular direction may be at least partially obstructed by one another when viewed along a line extending in the particular direction.

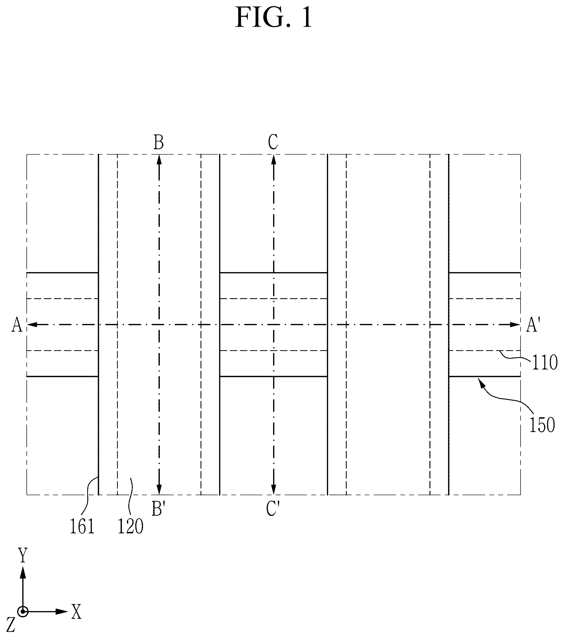

Referring FIGS. 1 to 5, a semiconductor device according to some implementations may include a substrate 100, a plurality of channel patterns 140 positioned on the substrate 100, a lower gate electrode 120A surrounding a plurality of lower channel patterns 140A of the plurality of channel patterns 140, an upper gate electrode 120B surrounding a plurality of upper channel patterns 140B of the plurality of channel patterns 140, a lower source/drain pattern 150A positioned on opposite sides of the lower channel patterns 140A, an upper source/drain pattern 150B positioned on opposite sides of the upper channel patterns 140B, and a barrier structure 300 positioned on the lower channel pattern 140A.

The substrate 100 may be silicon-on-insulator (SOI) or bulk silicon. Alternatively, the substrate 100 may be a silicon (Si) substrate, or may include other materials, such as but not limited to silicon germanium (SiGe), SGOI (silicon germanium on insulator), indium antimonide, lead telluride, indium arsenide, indium phosphide, gallium arsenide or gallium antimonide.

The substrate 100 may include an upper surface and a lower surface. The upper surface and the lower surface of the substrate 100 may be formed as planes parallel to a first direction (X direction) and a second direction (Y direction) intersecting the first direction (X direction). Accordingly, the first direction and the second direction may be parallel to the upper surface of the substrate 100. The upper surface of the substrate 100 may be a surface opposite to the lower surface of the substrate 100 in a third direction (Z direction). The third direction (Z direction) may be perpendicular to the upper surface of the substrate 100. The third direction (Z direction) may be perpendicular to the first direction (X direction) and the second direction (Y direction). The upper surface of the substrate 100 may be referred to as the front side. The lower surface of the substrate 100 may be referred to as the back side.

The terms "upper", "middle", "lower", "above", "below", etc. may refer to relative positions along a particular direction (e.g., the third direction (Z direction)). Various "levels" discussed herein (e.g., vertical levels) may refer to relative positions along the third direction (e.g., various distances from the upper surface of the substrate 100). Various directions (e.g., first direction, second direction third direction, etc.) may be defined relative to the structure of the devices described herein. It will be appreciated that these directions do not necessarily imply any particular orientation of the device in use. The terms "upper", "middle", "lower", etc. may be replaced with terms, such as "first", "second", third" to be used to describe relative positions of elements. The terms "first", "second", "third" may be used to describe various elements but the elements are not limited by the terms and a "first element" may be referred to as a "second element". Alternatively or additionally, the terms "first", "second", "third", etc. may be used to distinguish components from each other and do not limit the present disclosure. For example, the terms "first", "second", "third", etc. may not necessarily involve an order or a numerical meaning of any form.

A semiconductor device according to some implementations may include at least one transistor device positioned on a substrate 100. For example, a semiconductor device may include a first transistor TR1 including the plurality of lower channel patterns 140A and a second transistor TR2 including the plurality of upper channel patterns 140B. According to some implementations, each of the first transistor TR1 and the second transistor TR2 may be formed of a GAAFET (Gate All Around Field Effect Transistor) structure such as an MBCFET^{™} (Multi Bridge Channel Field Effect Transistor) in which the plurality of lower channel patterns 140A and the plurality of upper channel patterns 140B are surrounded by a gate electrode 120. In present context, a channel pattern being "surrounded by a gate electrode" may refer to the channel pattern being surrounded by the gate electrode in a cross-sectional view (e.g., taken along a plane passing along the second and third directions). For instance, the gate electrode may cover an upper surface, a lower surface, and two opposing side surfaces (e.g., in the second direction) of each channel pattern. Opposing end portions (e.g., in the first direction) of each channel pattern may be connected to a source/drain pattern (e.g., a lower source/drain pattern 150A or an upper source/drain pattern 150B).

Additionally, the first transistor TR1 and the second transistor TR2 according to some implementations may be formed in a 3D-SFET (three dimensional - stacked FET) structure stacked in the third direction (Z direction). In this case, the first transistor TR1 may be a first-conductivity metal-oxide-semiconductor field effect transistor (MOSFET), and the second transistor TR2 may be a second-conductivity MOSFET. For instance, the first transistor TR1 may be MOSFET of a first conductivity type, and the second transistor TR2 may be a MOSFET of a second conductivity type. Here, the first conductivity type may be P type and the second conductivity type may be N type. However, example implementations are not limited thereto, and the conductivity types of the first transistor TR1 and the second transistor TR2 may be changed in various ways. For example, the first transistor TR1 may be a second-conductivity MOSFET, and the second transistor TR2 may be a first-conductivity MOSFET. As another example, each of the first transistor TR1 and the second transistor TR2 may be a first-conductivity MOSFET. As another example, the first transistor TR1 and the second transistor TR2 may each be second-conductivity MOSFETs.

A semiconductor device according to some implementations may further include an active pattern 110 positioned on the substrate 100.

The active pattern 110 may be positioned on the substrate 100. The active pattern 110 may extend in the first direction (X direction). The active pattern 110 may have a structure protruding along the third direction (Z direction) from the substrate 100. The active pattern 110 may include one or more of various insulating materials. The active pattern 110 may comprise the same material as the substrate 100. As an example, the active pattern 110 may include silicon (Si).

A plurality of channel patterns 140 may be positioned on the active pattern 110. In some implementations, the plurality of channel patterns 140 may include a plurality of lower channel patterns 140A positioned on the active pattern 110 and a plurality of upper channel patterns 140B positioned on the plurality of lower channel patterns 140A.

A plurality of lower channel patterns 140A may be positioned on the upper surface of the active pattern 110. The plurality of lower channel patterns 140A may be spaced apart from the active pattern 110 in the third direction (Z direction). Here, the third direction (Z direction) may be a direction that intersects the first direction (X direction) and the second direction (Y direction). For example, the third direction (Z direction) may be the thickness direction of the substrate 100. The plurality of lower channel patterns 140A may be spaced apart from each other in the third direction (Z direction). Widths of the plurality of lower channel patterns 140A in the first direction (X direction) may be substantially the same, but example implementations are not limited thereto. As another example, the width of the plurality of lower channel patterns 140A in the first direction (X direction) may decrease with increasing distance from the upper surface of the substrate 100. The plurality of lower channel patterns 140A may be multi-channel active patterns.

In some implementations, the plurality of lower channel patterns 140A may include a semiconductor material. For example, the plurality of lower channel patterns 140A may include silicon (Si), an elemental semiconductor material. As another example, the plurality of lower channel patterns 140A may include germanium (Ge). The plurality of lower channel patterns 140A may be formed by etching a portion of the substrate 100, or may include an epitaxial layer grown from the substrate 100. The plurality of lower channel patterns 140A may be substantially undoped.

A plurality of upper channel patterns 140B may be positioned on a plurality of lower channel patterns 140A. Specifically, a plurality of upper channel patterns 140B may be positioned on a barrier structure 300 positioned on a plurality of lower channel patterns 140A. The plurality of upper channel patterns 140B may be spaced apart from the plurality of lower channel patterns 140A in the third direction (Z direction). For example, a barrier structure 300 may be positioned between a plurality of upper channel patterns 140B and a plurality of lower channel patterns 140A, and the plurality of upper channel patterns 140B may be spaced apart from the plurality of lower channel patterns 140A in the third direction (Z direction) by the barrier structure 300. Each of the plurality of upper channel patterns 140B may be spaced apart from each other in the third direction (Z direction). Widths of the plurality of upper channel patterns 140N in the first direction (X direction) may be substantially the same, but example implementations are not limited thereto. As another example, the widths of the plurality of upper channel patterns 140B in the first direction (X direction) may decrease with increasing distance from the upper surface of the substrate 100. In some implementations, the plurality of upper channel patterns 140B may be multi-channel active patterns.

The plurality of upper channel patterns 140B may include the same semiconductor material as the plurality of lower channel patterns 140A. For example, the plurality of upper channel patterns 140B may include silicon (Si), which is an elemental semiconductor material. As another example, the plurality of upper channel patterns 140B may include germanium (Ge). The plurality of upper channel patterns 140B may be formed by etching a portion of the substrate 100, or may include an epitaxial layer grown from the substrate 100. The plurality of upper channel patterns 140B may be substantially undoped.

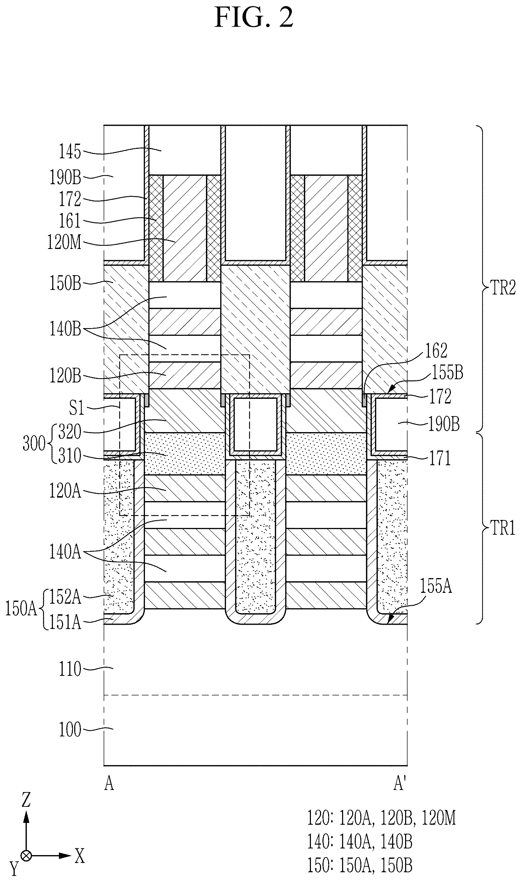

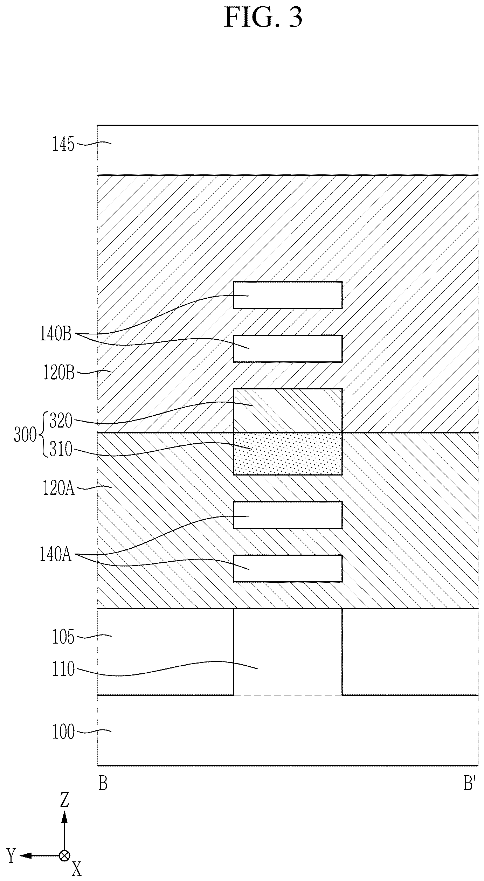

FIG. 2 and FIG. 3 illustrate that two lower channel patterns 140A and two upper channel patterns 140B are stacked and spaced apart along the third direction (Z direction), but this is only for convenience of explanation and is not limited thereto. For example, three or more the plurality of lower channel patterns 140A and/or three or more upper channel patterns 140B may be stacked spaced apart along the third direction (Z direction). Alternatively, one lower channel pattern 140A and/or one upper channel pattern 140B may be stacked spaced apart along the third direction (Z direction).

A semiconductor device according to some implementations may further include a field insulating layer 105 positioned on the substrate 100.

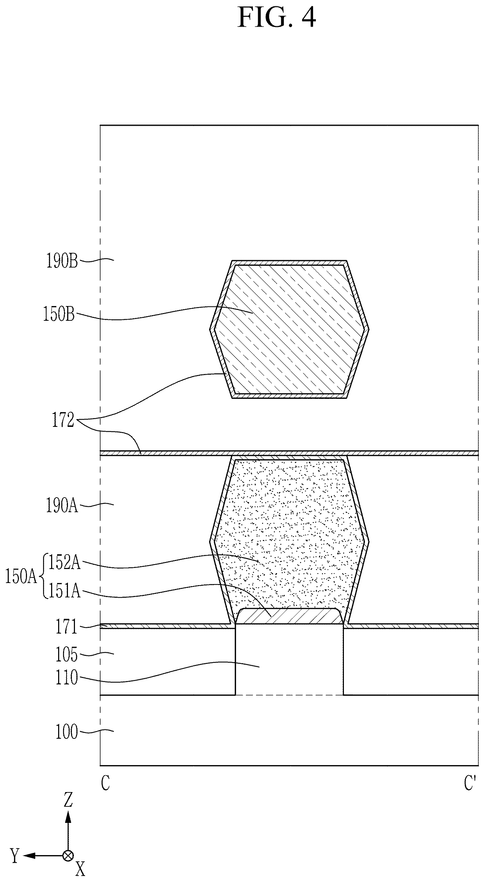

The field insulating layer 105 may be positioned on the substrate 100. The field insulating layer 105 may cover at least a portion of a side surface of the active pattern 110. For example, as illustrated in FIG. 3 and FIG. 4, the field insulating layer 105 may cover the side surface of the active pattern 110. The field insulating layer 105 may overlap the active pattern 110 in the second direction (Y direction). Additionally, the field insulating layer 105 may not be positioned on the upper surface of the active pattern 110. The field insulating layer 105 may include, for example, an oxide, a nitride, a nitride oxide or a combination thereof. Field insulating layer 105 is illustrated as a single film, but this is only for convenience of explanation and is not limited thereto.

A gate electrode 120 may be positioned on the active pattern 110. The gate electrode 120 may extend in the second direction (Y direction). The gate electrode 120 may intersect the active pattern 110. The gate electrode 120 may surround each of the plurality of channel patterns 140.

According to some implementations, the gate electrode 120 of the semiconductor device may include a lower gate electrode 120A, an upper gate electrode 120B, and a main gate electrode 120M.

The lower gate electrode 120A may be positioned on the active pattern 110. The lower gate electrode 120A may surround the plurality of lower channel patterns 140A. For instance, the lower gate electrode 120A may surround the plurality of upper channel patterns 140A in the second and third directions. For example, the lower gate electrode 120A may be positioned between the plurality of lower channel patterns 140A adjacent to each other in the third direction (Z direction), and between the active pattern 110 and the lowermost lower channel pattern 140A. Additionally, the lower gate electrode 120A may be positioned between the barrier structure 300 and the lower channel pattern 140A positioned at the top of the plurality of lower channel patterns 140A (e.g., the uppermost lower channel pattern). The lower gate electrode 120A may be in contact with the barrier structure 300 but example implementations are not limited thereto. The lower gate electrode 120A may be adjacent to the lower source/drain pattern 150A.

The upper gate electrode 120B may be positioned on the lower gate electrode 120A. The upper gate electrode 120B may overlap with the lower gate electrode 120A in the third direction (Z direction). The upper gate electrode 120B may surround the plurality of upper channel patterns 140B. For instance, the upper gate electrode 120B may surround the plurality of upper channel patterns 140B in the second and third directions. For example, the upper gate electrode 120B may be positioned between the plurality of upper channel patterns 140B adjacent to each other in the third direction (Z direction). Additionally, the upper gate electrode 120B may be positioned between the barrier structure 300 and the upper channel pattern positioned at the bottom of the plurality of upper channel patterns 140B (e.g., the lowermost upper channel pattern). The upper gate electrode 120B may be in contact with the barrier structure 300, but example implementations are not limited thereto. The upper gate electrode 120B may be adjacent to the upper source/drain pattern 150B.

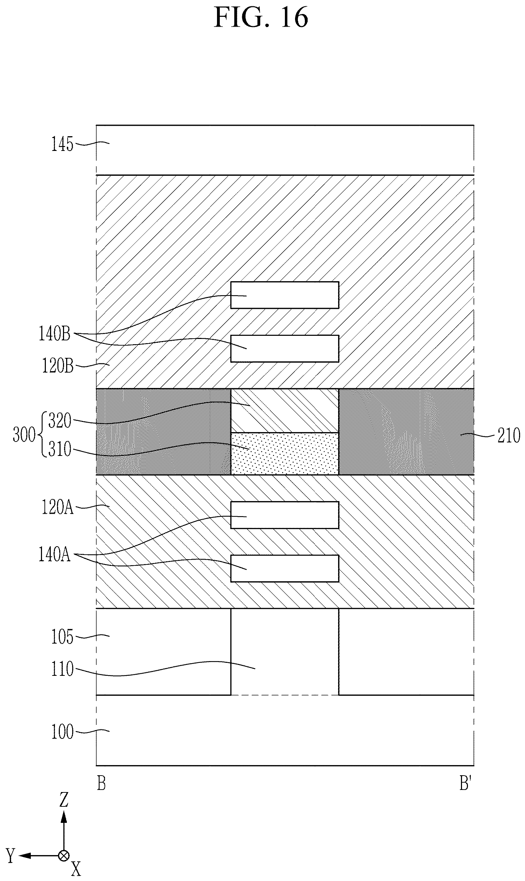

The upper gate electrode 120B may be in contact with the lower gate electrode 120A. For example, as illustrated in FIG. 3, a portion of the upper gate electrode 120B and a portion of the lower gate electrode 120A may be in contact with each other. A barrier structure 300 may be positioned between the remaining portion of the upper gate electrode 120B and the remaining portion of the lower gate electrode 120A. Accordingly, the upper gate electrode 120B and the lower gate electrode 120A may be connected (e.g., electrically connected) to each other, and the first transistor TR1 and the second transistor TR2 may be configured to share one gate signal. That is, when a gate signal is applied to the upper gate electrode 120B, the same gate signal is also applied to the lower gate electrode 120A, so that the first transistor TR1 and the second transistor TR2 may be configured to share one gate signal. However, example implementations are not limited thereto, and the lower gate electrode 120A and the upper gate electrode 120B may be separated so that the lower gate electrode 120A and the upper gate electrode 120B may not be electrically connected. Details are described below with reference to FIG. 16.

According to some implementations, each of the lower gate electrode 120A and the upper gate electrode 120B may include a plurality of layers, and the plurality of layers may be alternately stacked with a plurality of channel patterns 140.

The main gate electrode 120M may be positioned on the upper gate electrode 120B and the plurality of upper channel patterns 140B. The main gate electrode 120M may be positioned on the upper surface of the plurality of upper channel patterns 140B. The main gate electrode 120M may be positioned on the upper channel pattern 140B positioned at the top of the plurality of upper channel patterns 140B. In some embodiments, the main gate electrode 120M may be considered an uppermost portion of the upper gate electrode 120B.

The lower gate electrode 120A, the upper gate electrode 120B, and the main gate electrode 120M may include a conductive material. The lower gate electrode 120A and the upper gate electrode 120B may include the same material, but example implementations are not limited thereto. The lower gate electrode 120A and the upper gate electrode 120B may contain different materials. The lower gate electrode 120A, the upper gate electrode 120B, and the main gate electrode 120M may include at least one of a metal, a metal alloy, a conductive metal nitride, a metal silicide, a doped semiconductor material, a conductive metal oxide, and a conductive metal oxynitride. The lower gate electrode 120A, the upper gate electrode 120B, and the main gate electrode 120M may include, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbide nitride (TiAIC-N), titanium aluminum carbide (TiAIC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), It may include at least one of niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and combinations thereof, but example implementations are not limited thereto. The conductive metal oxides and conductive metal nitrides may include, but example implementations are not limited thereto, oxidized forms of the materials described above. In some implementations, the lower gate electrode 120A, the upper gate electrode 120B, and the main gate electrode 120M may comprise the same material and may be formed integrally. In this case, a boundary may not be recognized between the lower gate electrode 120A and the upper gate electrode 120B.

A semiconductor device according to some implementations may further include a gate insulating film positioned between the gate electrode 120 and the plurality of channel patterns 140.

The gate insulating film may be positioned along the perimeter of the plurality of channel patterns 140. For example, the lower gate insulating film may be positioned along the perimeter of the plurality of lower channel patterns 140A, and the upper gate insulating film may be positioned along the perimeter of the plurality of upper channel patterns 140B. Additionally, the lower gate insulating film may extend along the upper surface of the active pattern 110. Additionally, the gate insulating film may extend along the side surface of the main gate electrode 120M. The gate insulating film may extend along the side surface of a first gate spacer 161.

The gate insulating film may include one or more of various insulating materials. The gate insulating film may be composed of a single film or multiple films. For example, the gate insulating film may be formed of a multilayer including silicon oxide (SiO₂) and a high-k material. In this case, the high-k material may include a material having a higher dielectric constant than silicon oxide (SiO₂), such as hafnium oxide (HfO), aluminum oxide (AlO), or tantalum oxide (TaO).

A semiconductor device according to some implementations may further include a first gate spacer 161 and a capping layer 145.

The first gate spacer 161 may be positioned on the side surface of the main gate electrode 120M. The first gate spacer 161 may be positioned on opposing side surfaces of the main gate electrode 120M. The first gate spacer 161 may not be positioned between the active pattern 110 and the plurality of channel patterns 140. The first gate spacer 161 may not be positioned between the plurality of channel patterns 140 adjacent in the third direction (Z direction). The first gate spacer 161 may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and combinations thereof. The first gate spacer 161 is shown as being a single layer, but this is for convenience of explanation only and is not limited thereto.

The capping layer 145 may be positioned on the main gate electrode 120M and the first gate spacer 161. The upper surface of the capping layer 145 may be placed on the same plane as the upper surface of an upper interlayer insulating layer 190B. In some implementations, the capping layer 145 may also be positioned on the side surface of the first gate spacer 161. The capping layer 145 may include, for example, at least one of silicon nitride (SiN), silicon oxynitride (SiON), silicon carbon nitride (SiCN), silicon oxycarbonitride (SiOCN), and combinations thereof.

The source/drain patterns 150 may be positioned on at least one side of the gate electrode 120. For example, the source/drain patterns 150 may be positioned on opposite sides of the gate electrode 120 in the first direction (X direction). Source/drain patterns 150 may be positioned on the active pattern 110. The source/drain patterns 150 may contact the side surface of the plurality of channel patterns 140. The source/drain patterns 150 may be connected to the plurality of channel patterns 140.

The source/drain patterns 150 according to some implementations may include a lower source/drain pattern 150A and an upper source/drain pattern 150B positioned on the lower source/drain pattern 150A.

The lower source/drain pattern 150A may be positioned on the active pattern 110. The lower source/drain pattern 150A may be positioned on at least one side surface of the lower gate electrode 120A. For example, the lower source/drain pattern 150A may be positioned on opposite sides of the lower gate electrode 120A along the first direction (X direction). The lower source/drain pattern 150A may be connected to the plurality of lower channel patterns 140A.

The lower source/drain pattern 150A may be positioned within a lower source/drain recess 155A extending along the third direction (Z direction). The lower source/drain pattern 150A may fill the lower source/drain recess 155A. The bottom surface of the lower source/drain recess 155A may be defined by the active pattern 110. The inner sidewall of the lower source/drain recess 155A may be defined by a plurality of lower channel patterns 140A, a lower gate electrode 120A, and a barrier structure 300 as described below. At least a portion of the lower source/drain pattern 150A may be surrounded by the active pattern 110. The lower surface of the lower source/drain pattern 150A may be positioned closer to the upper surface of the substrate 100 than the lower surface of the plurality of lower channel patterns 140A.

At least a portion of the lower source/drain pattern 150A may overlap with the barrier structure 300 in the first direction (X direction). For example, at least a portion of the lower source/drain pattern 150A may overlap with the first barrier pattern 310 in the first direction (X direction). At least a portion of the lower source/drain pattern 150A may be in contact with the first barrier pattern 310.

The lower source/drain pattern 150A may be an epitaxial pattern formed by a selective epitaxial growth process using the active pattern 110 and the plurality of lower channel patterns 140A as seeds. Additionally, the lower source/drain pattern 150A may be epitaxial patterns formed by a selective epitaxial growth process using the barrier structure 300 described as a seed elsewhere in this disclosure. The lower source/drain pattern 150A may serve as the source/drain of the first transistor TR1 that uses the plurality of lower channel patterns 140A as a channel region.

The lower source/drain pattern 150A may have a predetermined conductivity type. For example, the lower source/drain pattern 150A may have a first conductivity type. The lower source/drain pattern 150A may be doped with first conductivity type impurities. Here, the first conductivity type may be P type, but example implementations are not limited thereto (for instance, the first conductivity type may alternatively be N type). As an example, the lower source/drain pattern 150A may include B, V, In, Ga, Al, or a combination thereof.

A lower source/drain pattern 150A of a semiconductor device according to some implementations may include a first lower source/drain layer 151A and a second lower source/drain layer 152A.

The first lower source/drain layer 151A may be positioned on the side surfaces of the plurality of lower channel patterns 140A and the upper surface of the active pattern 110. Additionally, the first lower source/drain layer 151A may be positioned on the side surface of the barrier structure 300. The first lower source/drain layer 151A may be positioned within the lower source/drain recess 155A. The first lower source/drain layer 151A may be conformally positioned within the lower source/drain recess 155A. At least a portion of the first lower source/drain layer 151A may be in contact with a side surface of the barrier structure 300. For example, at least a portion of the first lower source/drain layer 151A may be in contact with the side surface 310_S of the first barrier pattern 310 of the barrier structure 300. This may be due to the process characteristics of forming the first lower source/drain layer 151A through a selective epitaxial growth process using the barrier structure 300 as a seed. The first lower source/drain layer 151A may include a semiconductor material. For example, the first lower source/drain layer 151A may include a semiconductor material such as silicon (Si) or silicon germanium (SiGe).

The second lower source/drain layer 152A may be positioned on the first lower source/drain layer 151A. The second lower source/drain layer 152A may fill the remaining portion of the lower source/drain recess 155A filled by the first lower source/drain layer 151A. The second lower source/drain layer 152A may be surrounded by the first lower source/drain layer 151A. The upper surface of the second lower source/drain layer 152A may be positioned at the same level as the upper surface of the first lower source/drain layer 151A. The second lower source/drain layer 152A may be spaced apart from the barrier structure 300. For example, a first lower source/drain layer 151A may be positioned between the second lower source/drain layer 152A and the first barrier pattern 310. The second lower source/drain layer 152A may include a semiconductor material. As an example, the second lower source/drain layer 152A may include a semiconductor material such as silicon (Si) or silicon germanium (SiGe).

In some implementations, the first lower source/drain layer 151A and the second lower source/drain layer 152A may each have the first conductivity type. The first lower source/drain layer 151A and the second lower source/drain layer 152A may be doped with impurities having the first conductivity type. Here, the first conductivity type may be P type. However, example implementations are not limited thereto, the first lower source/drain layer 151A and the second lower source/drain layer 152A may have a second conductivity type different from the first conductivity type.

In some implementations, the lower source/drain pattern 150A is described as being formed of a double layer, but example implementations are not limited thereto, and the lower source/drain pattern 150A may be formed of a single layer or three or more layers including a semiconductor material.

In some implementations, the upper source/drain pattern 150B of the semiconductor device may be positioned on the lower source/drain pattern 150A.

The upper source/drain pattern 150B may be spaced apart from the lower source/drain pattern 150A in the third direction (Z direction). For example, an upper interlayer insulating layer 190B may be positioned between the upper source/drain pattern 150B and the lower source/drain pattern 150A, and the upper source/drain pattern 150B and the lower source/drain pattern 150A may be spaced apart by the upper interlayer insulating layer 190B. Accordingly, the upper source/drain pattern 150B and the lower source/drain pattern 150A may not be electrically connected (e.g., may be electrically insulated from each other).

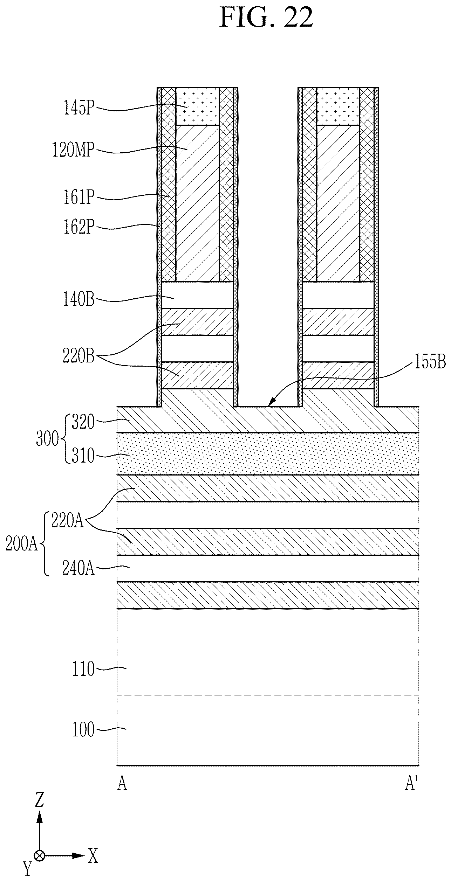

The width along the first direction (X direction) of the upper source/drain pattern 150B may be greater than the width along the first direction (X direction) of the lower source/drain pattern 150A. This may be due to the process characteristics of forming the upper source/drain recess 155B, forming the second preliminary gate spacer (see 162P of FIG. 22) within the upper source/drain recess 155B, and then forming the lower source/drain recess 155A. However, example implementations are not limited thereto, and the width along the first direction (X direction) of the upper source/drain pattern 150B may be smaller than or equal to the width along the first direction (X direction) of the lower source/drain pattern 150A.

The upper source/drain pattern 150B may be positioned on at least one side of the upper gate electrode 120B. For example, the upper source/drain pattern 150B may be positioned on opposite sides of the upper gate electrode 120B. The upper source/drain pattern 150B may be connected to the plurality of upper channel patterns 140B.

The upper source/drain pattern 150B may be positioned within an upper source/drain recess 155B extending along the third direction (Z direction). The upper source/drain pattern 150B may fill the upper source/drain recess 155B. The bottom surface of the upper source/drain recess 155B may be defined by the upper interlayer insulating layer 190B. The inner sidewall of the upper source/drain recess 155B may be defined by a plurality of upper channel patterns 140B and an upper gate electrode 120B.

At least a portion of the upper source/drain pattern 150B may overlap with the barrier structure 300 in the first direction (X direction). For example, at least a portion of the upper source/drain pattern 150B may overlap with the second barrier pattern 320 in the first direction (X direction). At least a portion of the upper source/drain pattern 150B may be in contact with the second barrier pattern 320.

The upper source/drain pattern 150B may be epitaxial patterns formed by a selective epitaxial growth process using the plurality of upper channel patterns 140B as seeds. In this case, the upper source/drain pattern 150B may be a pattern formed using only the side surfaces of the plurality of upper channel patterns 140B as seeds. In contrast to the plurality of lower source/drain patterns 150A, which is formed using both the upper surface of the active pattern 110 and the side surfaces of the lower channel patterns 140A, the upper source/drain pattern 150B may be formed only using the side surfaces of the plurality of upper channel patterns 140B. The upper source/drain pattern 150B may serve as the source/drain of the second transistor TR2, which uses the plurality of upper channel patterns 140B as a channel region.

The upper source/drain pattern 150B may have a predetermined conductivity type. For example, the upper source/drain pattern 150B may have a second conductivity type that is different from the first conductivity type. The upper source/drain pattern 150B may be doped with second conductivity type impurities. Here, the second conductivity type may be N type but example implementations are not limited thereto (for instance, the second conductivity type may alternatively be P type). As an example, the upper source/drain pattern 150B may include P, Sb, As, or a combination thereof. The upper source/drain pattern 150B may have a different conductivity type than the lower source/drain pattern 150A, but example implementations are not limited thereto, and the upper source/drain pattern 150B may have the same conductivity type as the lower source/drain pattern 150A.

In some implementations, the upper source/drain pattern 150B is described as being formed of a single layer, but example implementations are not limited thereto, and the upper source/drain pattern 150B may be formed of the plurality of layers including semiconductor materials.

A semiconductor device according to some implementations may further include a lower interlayer insulating layer 190A and an upper interlayer insulating layer 190B.

As illustrated in FIG. 4, the lower interlayer insulating layer 190A may be positioned on the field insulating layer 105. The lower interlayer insulating layer 190A may surround at least a portion of the lower source/drain pattern 150A. For example, the lower interlayer insulating layer 190A may be positioned on opposite sides of the lower source/drain pattern 150A along the second direction (Y direction). The lower interlayer insulating layer 190A may include, for example, at least one of silicon oxide (SiO₂), silicon nitride (SiN), silicon oxynitride (SiON), and a low-k material. A low-k material may be a material having a lower dielectric constant than silicon oxide. Low-k materials (e.g., low dielectric constant materials) include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ (Tonen SilaZen), FSG (Fluoride Silicate GlaSS), polyimide nanofoams such as polypropylene oxide, CDO (Carbon Doped Silicon Oxide), OSG (Organo) Silicate GlaSS), SiLK, Amorphous Fluorinated Carbon, silica aerogels, silica xerogels, mesoporous silica or combinations thereof, but example implementations are not limited thereto.

The upper interlayer insulating layer 190B may be positioned on the lower interlayer insulating layer 190A. The upper interlayer insulating layer 190B may surround at least a portion of the upper source/drain pattern 150B. For example, as illustrated in FIG. 4, the upper interlayer insulating layer 190B may be positioned on the lower surface, side surfaces (e.g., in the second direction), and upper surface of the upper source/drain pattern 150B. The upper interlayer insulating layer 190B may completely surround the upper source/drain pattern 150B (e.g., in a plane defined by the second and third directions), but example implementations are not limited thereto. The upper interlayer insulating layer 190B may be positioned between the upper source/drain pattern 150B and the lower source/drain pattern 150A. Additionally, the upper interlayer insulating layer 190B may be positioned on the side surface of the first gate spacer 161 and the side surface of the capping layer 145. The upper interlayer insulating layer 190B may not cover the upper surface of the capping layer 145. The upper surface of the upper interlayer insulating layer 190B may be positioned at substantially the same level as the upper surface of the capping layer 145. The upper interlayer insulating layer 190B may include one or more of various insulating materials. The upper interlayer insulation layer 190B may include, but example implementations are not limited thereto, the same material as the lower interlayer insulation layer 190A.

A semiconductor device according to some implementations may further include a first liner film 171 and a second liner film 172.

The first liner film 171 may be positioned between the lower interlayer insulating layer 190A and the lower source/drain pattern 150A. The first liner film 171 may surround at least a portion of the lower source/drain pattern 150A. For example, the first liner film 171 may be positioned on opposite side surfaces and the upper surface of the lower source/drain pattern 150A. The first liner film 171 may be positioned between the lower interlayer insulating layer 190A and the field insulating layer 105. The first liner film 171 may be positioned on opposite side surfaces of the barrier structure 300. For example, as illustrated in FIG. 2, the first liner film 171 may be positioned on opposite side surfaces in the first direction (X direction) of the barrier structure 300.

The first liner film 171 may contain one or more of various insulating materials. The first liner film 171 may include a different material than the lower interlayer insulating layer 190A, but example implementations are not limited thereto. For example, the first liner film 171 may include at least one of silicon nitride (SiN), silicon oxynitride (SiON), silicon oxycarbonitride (SiOCN), silicon boron nitride (SiBN), silicon oxyboron nitride (SiOBN), silicon oxycarbide (SiOC), and combinations thereof.

The second liner film 172 may be positioned between the upper interlayer insulating layer 190B and the upper source/drain pattern 150B. The second liner film 172 may surround at least a portion of the upper source/drain pattern 150B. For example, the second liner film 172 may be positioned on the lower surface, opposite side surfaces (e.g., in the second direction), and the upper surface of the upper source/drain pattern 150B. The second liner film 172 may completely surround the upper source/drain pattern 150B (e.g., in a plane defined by the second and third directions). The second liner film 172 may be positioned between the upper interlayer insulating layer 190B and the lower interlayer insulating layer 190A. Additionally, the second liner film 172 may be positioned on a portion of the first liner film 171 that is positioned on the upper surface of the lower source/drain pattern 150A. As illustrated in FIG. 2, the second liner film 172 may be positioned on a side surface of a portion of the first liner film 171 that is positioned on a side surface of the upper interlayer insulating layer 190B.

The second liner film 172 may contain one or more of various insulating materials. The second liner film 172 may contain the same material as the first liner film 171. The second liner film 172 may include, but example implementations are not limited thereto, a different material than the upper interlayer insulating layer 190B. For example, the second liner film 172 may include at least one of silicon nitride (SiN), silicon oxynitride (SiON), silicon oxycarbonitride (SiOCN), silicon boron nitride (SiBN), silicon oxyboron nitride (SiOBN), silicon oxycarbide (SiOC), and combinations thereof.

The barrier structure 300 may be positioned on the plurality of lower channel patterns 140A. The barrier structure 300 may be positioned between the plurality of lower channel patterns 140A and the plurality of upper channel patterns 140B. The barrier structure 300 may be positioned between the lower channel pattern 140A positioned at the uppermost position and the upper channel pattern 140B positioned at the lowermost position. The barrier structure 300 may be positioned on the lower gate electrode 120A. The barrier structure 300 may be positioned between the lower gate electrode 120A and the upper gate electrode 120B. The barrier structure 300 may be in contact with the lower gate electrode 120A and the upper gate electrode 120B.

The barrier structure 300 may overlap the upper interlayer insulating layer 190B in the first direction (X direction). The side surface of the barrier structure 300 may be in contact with the upper interlayer insulating layer 190B, but example implementations are not limited thereto. At least a portion of the barrier structure 300 may overlap the lower source/drain pattern 150A in the first direction (X direction). The side surface of the barrier structure 300 may be in contact with the lower source/drain pattern 150A, but example implementations are not limited thereto. Additionally, at least a portion of the barrier structure 300 may overlap the upper source/drain pattern 150B in the first direction (X direction). The side surface of the barrier structure 300 may be in contact with the upper source/drain pattern 150B, but example implementations are not limited thereto. The side surface of the barrier structure 300 may be in contact with the first liner film 171, but example implementations are not limited thereto.

The barrier structure 300 may include a semiconductor material. The barrier structure 300 may include the same material as the plurality of lower channel patterns 140A and the plurality of upper channel patterns 140B. The barrier structure 300 may comprise the same material as the substrate 100 and the active pattern 110. For example, the barrier structure 300 may include silicon (Si). In some implementations, the substrate 100, the active pattern 110, the plurality of lower channel patterns 140A, and the plurality of upper channel patterns 140B may include silicon (Si).

A barrier structure 300 of a semiconductor device according to some implementations may include a first barrier pattern 310 positioned on the plurality of lower channel patterns 140A and a second barrier pattern 320 positioned between the first barrier pattern 310 and the plurality of upper channel patterns 140B.

The first barrier pattern 310 may be positioned on the plurality of lower channel patterns 140A. For example, the first barrier pattern 310 may be positioned on the lower gate electrode 120A. The first barrier pattern 310 may be positioned directly on (e.g., contacting) the upper surface of the lower gate electrode 120A, but example implementations are not limited thereto. As another example, the first barrier pattern 310 may be positioned directly on (e.g., contacting) the upper surface of the lower channel pattern 140A, which is positioned at the top of the plurality of lower channel patterns 140A.

The first barrier pattern 310 may be positioned on the side surface of the upper interlayer insulating layer 190B. The first barrier pattern 310 may overlap the upper interlayer insulating layer 190B in the first direction (X direction). The first barrier pattern 310 may be positioned on the side surface of the first liner film 171. The side surface of the first barrier pattern 310 may be in contact with the first liner film 171, but example implementations are not limited thereto. The lower surface of the first barrier pattern 310 may be positioned at a lower level than the lower surface of the upper interlayer insulating layer 190B. The lower surface of the first barrier pattern 310 may be positioned closer to the upper surface of the substrate 100 than the lower surface of the upper interlayer insulating layer 190B. That is, the distance between the lower surface of the first barrier pattern 310 and the upper surface of the substrate 100 (e.g., in the third direction) may be less than the distance between the lower surface of the upper interlayer insulating layer 190B and the upper surface of the substrate 100 (e.g., in the third direction).

Additionally, at least a portion of the first barrier pattern 310 may overlap the lower source/drain pattern 150A in the first direction (X direction). At least a portion of the first barrier pattern 310 may be in contact with the lower source/drain pattern 150A. For example, at least a portion of the first barrier pattern 310 may be in contact with the first lower source/drain layer 151A. The first barrier pattern 310 may be spaced apart from the second lower source/drain layer 152A. This may be due to the process characteristics of forming the lower source/drain pattern 150A by a selective epitaxial growth process using the barrier structure 300 as a seed. Accordingly, the lower surface of the first barrier pattern 310 may be positioned at a lower level than the upper surface of the lower source/drain pattern 150A. The lower surface of the first barrier pattern 310 may be positioned closer to the upper surface of the substrate 100 than the upper surface of the lower source/drain pattern 150A. A distance between the lower surface of the first barrier pattern 310 and the upper surface of the substrate 100 may be less than a distance between the upper surface of the lower source/drain pattern 150A and the upper surface of the substrate 100. A distance between the upper surface of the first barrier pattern 310 and the upper surface of the substrate 100 may be longer than a distance between the upper surface of the lower source/drain pattern 150A and the upper surface of the substrate 100.

The first barrier pattern 310 may be spaced apart from the upper source/drain pattern 150B. The first barrier pattern 310 may not overlap with the upper source/drain pattern 150B in the first direction (X direction). The upper surface 310_U of the first barrier pattern 310 may be positioned at a lower level than the lower surface of the upper source/drain pattern 150B. That is, the upper surface 310_U of the first barrier pattern 310 may be positioned closer to the upper surface of the substrate 100 than the lower surface of the upper source/drain pattern 150B.

The first barrier pattern 310 may have a predetermined conductivity type. The first barrier pattern 310 may have a different conductivity type than the lower source/drain pattern 150A. For example, if the lower source/drain pattern 150A has the first conductivity type, the first barrier pattern 310 may have a second conductivity type different from the first conductivity type. The first barrier pattern 310 may be doped with impurities having a second conductivity type. Here, the second conductivity type may be N type. For example, the first barrier pattern 310 may include P, Sb, As, or a combination thereof.

In some implementations, a doping concentration of the impurities in the first barrier pattern 310 may be less than or equal to a doping concentration of the impurities in the lower source/drain pattern 150A. The doping concentration of the impurity of the first barrier pattern 310 may be less than or equal to a doping concentration of the impurity of the plurality of lower channel patterns 140A. In this range, the first barrier pattern 310 may prevent leakage current from occurring between the lower source/drain pattern 150A positioned on opposite sides along the first direction (X direction) of the lower gate electrode 120A. Accordingly, the first barrier pattern 310 may act to reduce or prevent leakage between opposite lower source/drain regions (on opposite sides of the plurality of lower channel patterns 140A in the first direction).

However, example implementations are not limited thereto, and as another example, when the lower source/drain pattern 150A has a second conductivity type, the first barrier pattern 310 may have a first conductivity type different from the second conductivity type. The first barrier pattern 310 may be doped with an impurity having the first conductivity type. Here, the first conductivity type may be P type. For example, the first barrier pattern 310 may include B, V, In, Ga, Al, or a combination thereof.

The second barrier pattern 320 may be positioned on the first barrier pattern 310. The second barrier pattern 320 may be positioned between the first barrier pattern 310 and the plurality of upper channel patterns 140B. For example, the second barrier pattern 320 may be positioned between the first barrier pattern 310 and the upper channel pattern 140B positioned at the bottom of the plurality of upper channel patterns 140B. The second barrier pattern 320 may be positioned on the lower gate electrode 120A. The second barrier pattern 320 may be positioned between the first barrier pattern 310 and the upper gate electrode 120B. The second barrier pattern 320 may be in contact with the first barrier pattern 310 and the upper gate electrode 120B, but example implementations are not limited thereto. As another example, the second barrier pattern 320 may contact the upper channel pattern 140B positioned at the bottom.

The second barrier pattern 320 may be positioned on the side surface of the upper interlayer insulating layer 190B. The second barrier pattern 320 may overlap the upper interlayer insulating layer 190B in the first direction (X direction). The second barrier pattern 320 may be positioned on the side surface of the second liner film 172. The side surface of the second barrier pattern 320 may be in contact with the second liner film 172, but example implementations are not limited thereto. The lower surface of the second barrier pattern 320 may be positioned at a lower level than the upper surface of the upper interlayer insulating layer 190B. The lower surface of the second barrier pattern 320 may be positioned closer to the upper surface of the substrate 100 than the upper surface of the upper interlayer insulating layer 190B.

Additionally, at least a portion of the second barrier pattern 320 may overlap with the upper source/drain pattern 150B in the first direction (X direction). At least a portion of the second barrier pattern 320 may be in contact with the upper source/drain pattern 150B. The upper surface of the second barrier pattern 320 may be positioned at a higher level than the upper surface of the lower source/drain pattern 150A. The upper surface of the second barrier pattern 320 may be positioned farther from the upper surface of the substrate 100 than the upper surface of the lower source/drain pattern 150A. A distance between the upper surface of the second barrier pattern 320 and the upper surface of the substrate 100 may be longer than a distance between the upper surface of the lower source/drain pattern 150A and the upper surface of the substrate 100. This may be due to the process characteristics of forming the upper source/drain pattern 150B by a selective epitaxial growth process using the barrier structure 300 as a seed. The second barrier pattern 320 may not overlap with the lower source/drain pattern 150A in the first direction (X direction).

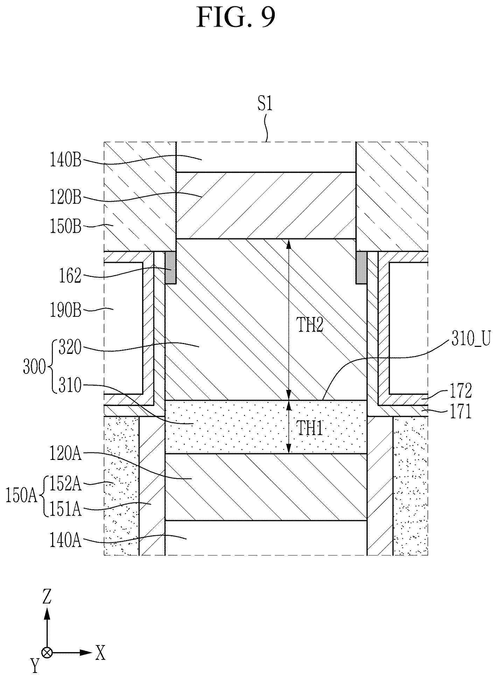

The thickness of the second barrier pattern 320 in the third direction (Z direction) may be substantially the same as the thickness of the first barrier pattern 310 in the third direction (Z direction). However, example implementations are not limited thereto, and the thickness of the second barrier pattern 320 in the third direction (Z direction) may be different from the thickness of the first barrier pattern 310 in the third direction (Z direction). Details are described below with reference to FIG. 9.

The second barrier pattern 320 may include the same semiconductor material as the first barrier pattern 310. For example, the first barrier pattern 310 and the second barrier pattern 320 may include silicon (Si). The second barrier pattern 320 may have a predetermined conductivity type. The second barrier pattern 320 may have a different conductivity type than the upper source/drain pattern 150B. For example, if the upper source/drain pattern 150B has a second conductivity type, the second barrier pattern 320 may have a first conductivity type different from the second conductivity type. The second barrier pattern 320 may be doped with impurities having the first conductivity type. Here, the first conductivity type may be P type. For example, the second barrier pattern 320 may include B, V, In, Ga, Al, or a combination thereof.

The second barrier pattern 320 may have a different conductivity type than the first barrier pattern 310. For example, if the first barrier pattern 310 has a second conductivity type, the second barrier pattern 320 may have a first conductivity type that is different from the second conductivity type. In this case, the second barrier pattern 320 may have the same conductivity type as the lower source/drain pattern 150A and a different conductivity type from the upper source/drain pattern 150B. However, example implementations are not limited thereto, and the second barrier pattern 320 may have the same conductivity type as the first barrier pattern 310, as long as it differs from the conductivity type of the upper source/drain pattern 150B.

In some implementations, a doping concentration of the impurities in the second barrier pattern 320 may be less than or equal to the doping concentration of the impurities in the upper source/drain pattern 150B. The doping concentration of the impurity of the second barrier pattern 320 may be less than or equal to a doping concentration of the impurity of the plurality of upper channel patterns 140B. In this range, the second barrier pattern 320 may prevent leakage current from occurring between the upper source/drain pattern 150B positioned on opposite sides along the first direction (X direction) of the upper gate electrode 120B. Accordingly, the second barrier pattern 320 may act to reduce or prevent leakage between opposite upper source/drain regions (on opposite sides of the plurality of upper channel patterns 140B in the first direction).

However, example implementations are not limited thereto, and as another example, when the upper source/drain pattern 150B has a first conductivity type, the second barrier pattern 320 may have a second conductivity type different from the first conductivity type. The second barrier pattern 320 may be doped with an impurity having a second conductivity type. Here, the second conductivity type may be N type. For example, the second barrier pattern 320 may include P, Sb, As, or a combination thereof.

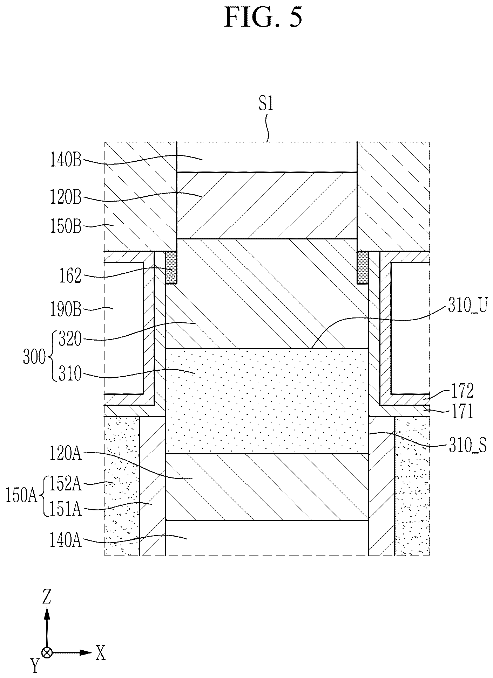

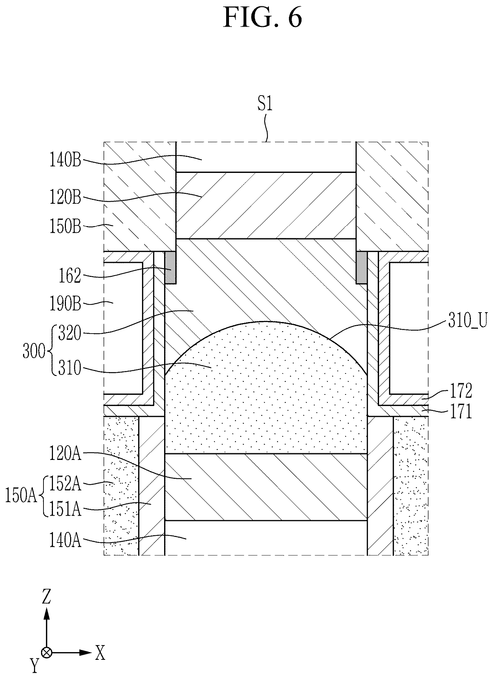

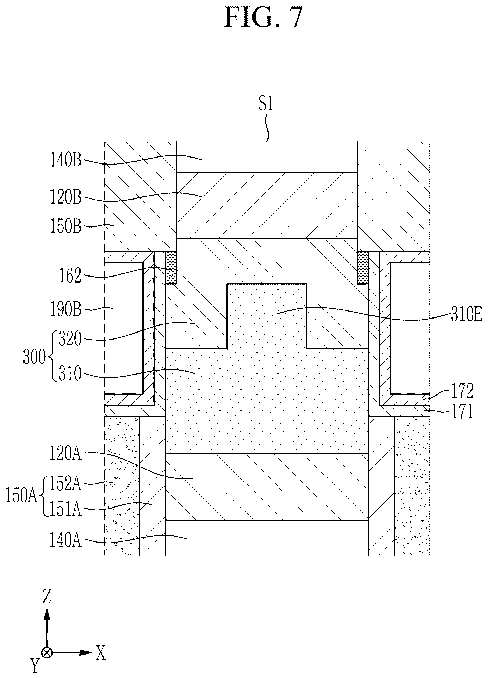

In some implementations, the first barrier pattern 310 and the second barrier pattern 320 may form a PN interface. The PN interface may be defined as the upper surface 310_U of the first barrier pattern 310 and the lower surface of the second barrier pattern 320, which are bonded together. The upper surface of the first barrier pattern 310 may have a shape complementary to the lower surface of the second barrier pattern 320. As illustrated in FIG. 5, the PN interface may be flat in the cross-section formed in the first direction (X direction) and the third direction (Z direction), but example implementations are not limited thereto. Details are described below with reference to FIG. 6 and 7.

In this case, since the first barrier pattern 310 and the second barrier pattern 320 have different conductive types, a depletion region may be formed by a PN junction at the interface between the first barrier pattern 310 and the second barrier pattern 320. Accordingly, the barrier structure 300 may prevent leakage current from occurring between the lower source/drain pattern 150A and the upper source/drain pattern 150B, and improve the reliability of the semiconductor device according to some implementations. Accordingly, the barrier structure 300 may act to reduce or prevent leakage between the lower source/drain pattern 150A and the upper source/drain pattern 150B.

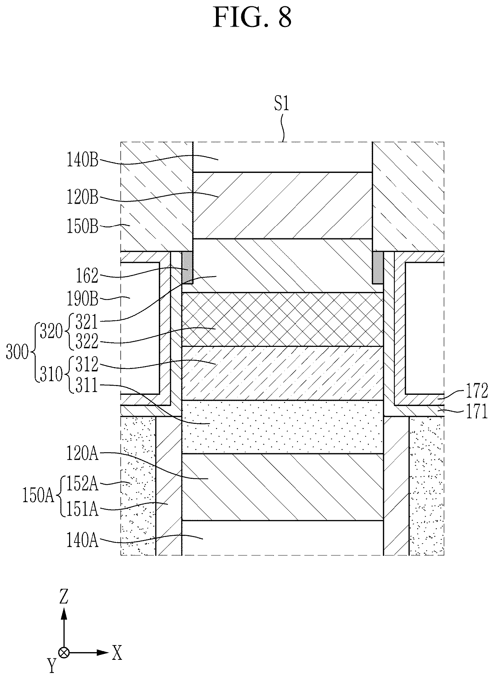

Although FIG. 1 to FIG. 5 illustrate that the barrier structure 300 includes a first barrier pattern 310 and a second barrier pattern 320, example implementations are not limited thereto. For example, the barrier structure 300 may include three or more layers. In this case, some layers of the barrier structure 300 may have the first conductivity type, and the remaining layers may have the second conductivity type. Details are described below with reference to FIG. 8 to 15.

A semiconductor device according to some implementations may further include a second gate spacer 162 positioned between the barrier structure 300 and the first liner film 171.

The second gate spacer 162 may be positioned on a side surface of the barrier structure 300. For example, the second gate spacer 162 may be positioned on a side surface of the second barrier pattern 320. The second gate spacer 162 may overlap the second barrier pattern 320 in the first direction (X direction). The second gate spacer 162 may not overlap with the first barrier pattern 310 in the first direction (X direction), but example implementations are not limited thereto. Accordingly, a part of the side surface of the second barrier pattern 320 may be in contact with the second gate spacer 162, and the remaining part may be in contact with the first liner film 171. The second gate spacer 162 may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and combinations thereof. The second gate spacer 162 is shown as being a single layer, but this is for convenience of explanation only. However, example implementations are not limited thereto.

Hereinafter, referring to FIGS. 6 to 16, a laminated structure of a semiconductor device according to some implementations will be described.

FIGS. 6 to 15 are cross-sectional views corresponding to area S1 of FIG. 2, illustrating semiconductor devices according to some implementations. FIG. 16 is a cross-sectional view corresponding to B-B' of FIG. 1, illustrating a semiconductor device according to some implementations.

The implementations illustrated in FIGS. 6 to 16 are substantially the same as the implementations illustrated in FIGS. 1 to 5, so a description thereof will be omitted and the differences will be mainly explained.

Referring to FIG. 6, the first barrier pattern 310 and the second barrier pattern 320 of the semiconductor device according to some implementations may have various shapes. For example, as illustrated in FIG. 6, the upper surface 310_U of the first barrier pattern 310 may have a convex shape toward the plurality of upper channel patterns 140B, and the lower surface of the second barrier pattern 320 may have a concave shape. For instance, the upper surface 310_U of the first barrier pattern 310 may protrude towards the upper channel patterns 140B, and the lower surface of the second barrier pattern 320 may be recessed towards the upper channel patterns 140B. The upper surface of the first barrier pattern 310 may have a complementary shape to the lower surface of the second barrier pattern 320. Accordingly, the PN interface between the first barrier pattern 310 and the second barrier pattern 320 may have a convex shape toward the plurality of upper channel patterns 140B. However, example implementations are not limited thereto, and as another example, the upper surface 310_U of the first barrier pattern 310 may have a concave shape toward the upper gate electrode 120B.

Referring to FIG. 7, the first barrier pattern 310 may include a protrusion portion 310E protruding toward the plurality of upper channel patterns 140B. The protrusion portion 310E may extend in the third direction (Z direction). The upper surface of the protrusion portion 310E may be positioned at a lower level than the upper surface of the second barrier pattern 320. That is, the upper surface of the protrusion portion 310E may be positioned closer to the upper surface of the substrate 100 than the upper surface of the second barrier pattern 320. Accordingly, the protrusion portion 310E may be spaced apart from the upper gate electrode 120B. The protrusion portion 310E may be spaced apart from the upper source/drain pattern 150B. The protrusion portion 310E may be surrounded by a second barrier pattern 320. The protrusion portion 310E may be positioned apart from the first liner film 171. That is, the second barrier pattern 320 may be positioned between the protrusion portion 310E and the first liner film 171.

Referring to FIG. 8, the first barrier pattern 310 and the second barrier pattern 320 may be formed of multiple layers. For example, the first barrier pattern 310 may include a first lower pattern 311 and a second lower pattern 312 sequentially positioned on the plurality of lower channel patterns 140A, and the second barrier pattern 320 may include a first upper pattern 322 and a second upper pattern 321 sequentially positioned on the second lower pattern 312.

In some implementations, the first lower pattern 311 and the second lower pattern 312 may have the same conductivity type. The first lower pattern 311 and the second lower pattern 312 may each have a different conductivity type from the lower source/drain pattern 150A. For example, if the lower source/drain pattern 150A has the first conductivity type, the first lower pattern 311 and the second lower pattern 312 may have a second conductivity type different from the first conductivity type. The first lower pattern 311 and the second lower pattern 312 may be doped with impurities having the second conductivity type. Here, the second conductivity type may be N type. For example, the first lower pattern 311 and the second lower pattern 312 may contain P, Sb, As, or a combination thereof.

A doping concentration of the impurity of the first lower pattern 311 may be less than or equal to the doping concentration of the impurity of the lower source/drain pattern 150A. The doping concentration of the impurity of the first lower pattern 311 may be less than or equal to the doping concentration of the impurity of the plurality of lower channel patterns 140A. A doping concentration of the impurity of the second lower pattern 312 may be less than or equal to the doping concentration of the impurity of the lower source/drain pattern 150A. The doping concentration of the impurity of the second lower pattern 312 may be less than or equal to the doping concentration of the impurity of the plurality of lower channel patterns 140A.

The doping concentration of the impurity of the second lower pattern 312 may be different from the doping concentration of the impurity of the first lower pattern 311. For example, the doping concentration of the impurity of the second lower pattern 312 may be less than or equal to the doping concentration of the impurity of the first lower pattern 311. However, example implementations are not limited thereto, and the doping concentration of the impurity of the second lower pattern 312 may be greater than the doping concentration of the impurity of the first lower pattern 311.

In some implementations, the first upper pattern 322 and the second upper pattern 321 may have the same conductivity type. The first upper pattern 322 and the second upper pattern 321 may each have different a conductivity type from the upper source/drain pattern 150B. For example, if the upper source/drain pattern 150B has a second conductivity type, the first upper pattern 322 and the second upper pattern 321 may have a first conductivity type different from the second conductivity type. The first upper pattern 322 and the second upper pattern 321 may be doped with impurities having the first conductivity type.

The doping concentration of the impurity of the first upper pattern 322 may be less than or equal to the doping concentration of the impurity of the upper source/drain pattern 150B. The doping concentration of the impurity of the first upper pattern 322 may be less than or equal to the doping concentration of the impurity of the plurality of upper channel patterns 140B. The doping concentration of the impurity of the second upper pattern 321 may be less than or equal to the doping concentration of the impurity of the upper source/drain pattern 150B. The doping concentration of the impurity of the second upper pattern 321 may be less than or equal to the doping concentration of the impurity of the plurality of upper channel patterns 140B.

The doping concentration of the impurity of the second upper pattern 321 may be different from the doping concentration of the impurity of the first upper pattern 322. For example, the doping concentration of the impurity of the second upper pattern 321 may be less than or equal to the doping concentration of the impurity of the first upper pattern 322. However, example implementations are not limited thereto, and the doping concentration of the impurity of the second upper pattern 321 may be greater than the doping concentration of the impurity of the first upper pattern 322.

Referring to FIG. 9, in some implementations, the thickness TH2 of the second barrier pattern 320 along the third direction (Z direction) may be different from the thickness TH1 of the first barrier pattern 310 along the third direction (Z direction). For example, the thickness TH2 of the second barrier pattern 320 along the third direction (Z direction) may be greater than the thickness TH1 of the first barrier pattern 310 along the third direction (Z direction). For example, if the thickness TH1 of the first barrier pattern 310 in the third direction (Z direction) is formed sufficiently small, the first barrier pattern 310 may not overlap with the upper interlayer insulating layer 190B in the first direction (X direction). However, example implementations are not limited thereto, and as another example, the thickness TH2 of the second barrier pattern 320 along the third direction (Z direction) may be smaller than the thickness TH1 of the first barrier pattern 310 along the third direction (Z direction).

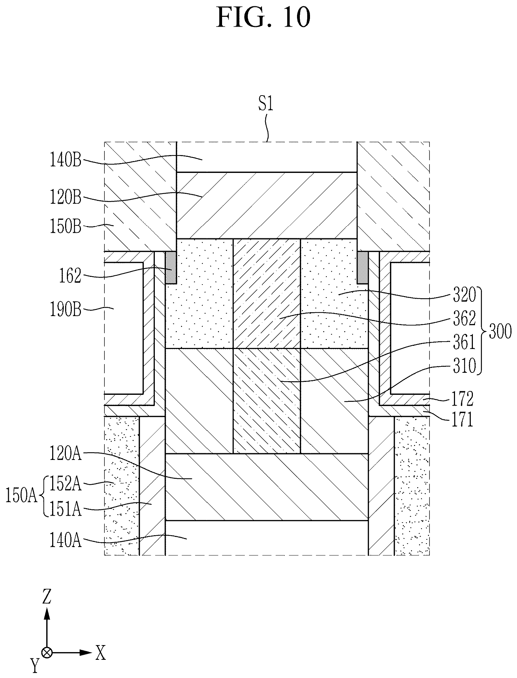

Referring to FIG. 10, in some implementations, the barrier structure 300 may further include a first shield pattern 361 positioned on one side of the first barrier pattern 310 and a second shield pattern 362 positioned on one side of the second barrier pattern 320.

The first shield pattern 361 may be positioned on the plurality of lower channel patterns 140A. The first shield pattern 361 may be positioned on the lower gate electrode 120A. The first shield pattern 361 may be positioned on one side of the first barrier pattern 310 in the first direction (X direction). The first shield pattern 361 may be positioned at the center of the first barrier pattern 310. The first barrier pattern 310 may be located on opposite sides of the first shield pattern 361 in the first direction (X direction). The side surface(s) of the first shield pattern 361 may contact the first barrier pattern 310. The thickness of the first shield pattern 361 along the third direction (Z direction) may be substantially the same as the thickness of the first barrier pattern 310 along the third direction (Z direction), but example implementations are not limited thereto. The first shield pattern 361 may be spaced apart from the lower source/drain pattern 150A in the first direction (X direction).

The first shield pattern 361 may have a different conductivity type than the first barrier pattern 310. For example, if the first barrier pattern 310 has a second conductivity type, the first shield pattern 361 may have a first conductivity type different from the second conductivity type. The first shield pattern 361 may be doped with impurities having the first conductivity type. Here, the first conductivity type may be P type. The first shield pattern 361 may contain B, V, In, Ga, Al, or a combination thereof. The first shield pattern 361 may have the same conductivity type as the lower source/drain pattern 150A. The first shield pattern 361 may have the same conductivity type as the second barrier pattern 320, but example implementations are not limited thereto.

The second shield pattern 362 may be placed on top of the first shield pattern 361. The second shield pattern 362 may be positioned on one side of the second barrier pattern 320 in the first direction (X direction). The second shield pattern 362 may overlap with the first shield pattern 361 in the third direction (Z direction), but example implementations are not limited thereto. The second shield pattern 362 may be positioned at the center of the second barrier pattern 320. The second barrier pattern 320 may be located on opposite sides of the second shield pattern 362 in the first direction (X direction). The lower surface of the second shield pattern 362 may contact the first shield pattern 361. The side surface(s) of the second shield pattern 362 may be in contact with the second barrier pattern 320. The thickness of the second shield pattern 362 in the third direction (Z direction) may be substantially the same as the thickness of the second barrier pattern 320 in the third direction (Z direction), but example implementations are not limited thereto. The second shield pattern 362 may be spaced apart from the upper source/drain pattern 150B in the first direction (X direction).

The second shield pattern 362 may have a different conductivity type than the second barrier pattern 320. For example, if the second barrier pattern 320 has a first conductivity type, the second shield pattern 362 may have a second conductivity type different from the first conductivity type. The second shield pattern 362 may be doped with impurities having a second conductivity type. Here, the second conductivity type may be N type. The second shield pattern 362 may contain P, Sb, As, or a combination thereof. The second shield pattern 362 may have the same conductivity type as the upper source/drain pattern 150B. The second shield pattern 362 may have a different conductivity type than the first shield pattern 361, but example implementations are not limited thereto. The second shield pattern 362 may have the same conductivity type as the first barrier pattern 310, but example implementations are not limited thereto.

In some implementations, since the first shield pattern 361 has a different conductivity type from the first barrier pattern 310 and the lower source/drain pattern 150A has a different conductivity type from the first barrier pattern 310, the barrier structure 300 may prevent leakage current from occurring between the lower source/drain pattern 150A positioned on opposite sides along the first direction (X direction) of the lower gate electrode 120A. In addition, since the second shield pattern 362 has a different conductivity type from the second barrier pattern 320 and the upper source/drain pattern 150B has a different conductivity type from the second barrier pattern 320, the barrier structure 300 may prevent leakage current from occurring between the upper source/drain pattern 150B positioned on opposite sides along the first direction (X direction) of the upper gate electrode 120B.

In the implementation of FIG. 10, the first shield pattern 361 and the second shield pattern 362 are described as having a predetermined conductivity type, but example implementations are not limited thereto. For example, the first shield pattern 361 and/or the second shield pattern 362 may be substantially undoped.

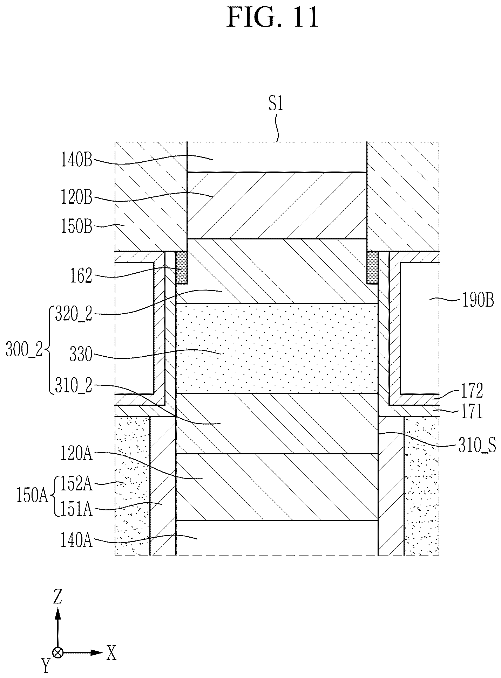

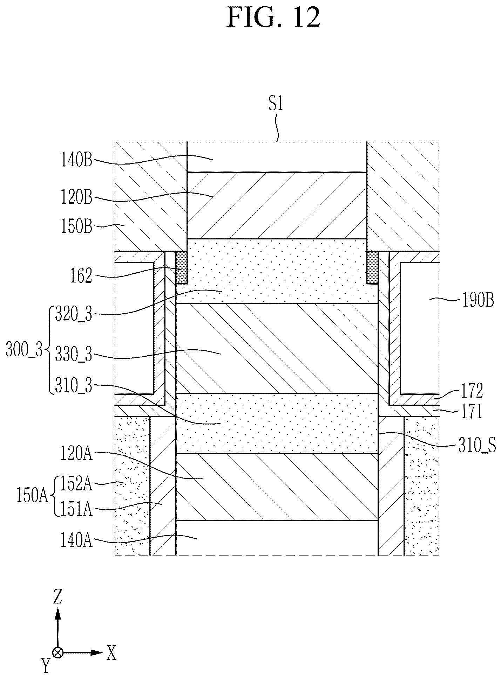

In the implementations of FIG. 11 to FIG. 13, the first barrier pattern 310_2 and the second barrier pattern 320_2 may have the same conductivity type. For example, as illustrated in FIG. 11, the lower source/drain pattern 150A and the upper source/drain pattern 150B may have a second conductivity type, and the first barrier pattern 310_2 and the second barrier pattern 320_2 may have a first conductivity type different from the second conductivity type. As another example, for the implementation of FIG. 12, the lower source/drain pattern 150A and the upper source/drain pattern 150B may have the first conductivity type, and the first barrier pattern 310_3 and the second barrier pattern 320_3 may have the second conductivity type different from the first conductivity type.

FIG. 11 and referring to FIG. 12, the barrier structure 300_2 of the semiconductor device according to some implementations may further include a third barrier pattern 330 positioned between the first barrier pattern 310_2 and the second barrier pattern 320_2.

The third barrier pattern 330 may be positioned on the first barrier pattern 310_2. The third barrier pattern 330 may overlap the upper interlayer insulating layer 190B in the first direction (X direction). The third barrier pattern 330 may be spaced apart from the lower source/drain pattern 150A and the upper source/drain pattern 150B in the third direction (Z direction), but example implementations are not limited thereto.

The third barrier pattern 330 may have a predetermined conductivity type. The third barrier pattern 330 may have a different conductivity type from the first barrier pattern 310_2 and the second barrier pattern 320_2. For example, in the implementation of FIG. 11, the first barrier pattern 310_2 and the second barrier pattern 320_2 may have a first conductivity type different from the second conductivity type. In this case, the third barrier pattern 330 may have a second conductivity type. Here, the first conductivity type may be P type and the second conductivity type may be N type. Accordingly, the barrier structure 300_2 may form a PN interface between the first barrier pattern 310_2 and the third barrier pattern 330 and between the third barrier pattern 330 and the second barrier pattern 320_2.

As another example, for the implementation of FIG. 12, the first barrier pattern 310_3 and the second barrier pattern 320_3 may have a second conductivity type different from the first conductivity type. In this case, the third barrier pattern 330_3 may have a first conductivity type. Here, the first conductivity type may be P type and the second conductivity type may be N type. Accordingly, the barrier structure 300_3 may form a PN interface between the first barrier pattern 310_3 and the third barrier pattern 330_3 and between the third barrier pattern 330_3 and the second barrier pattern 320_3.

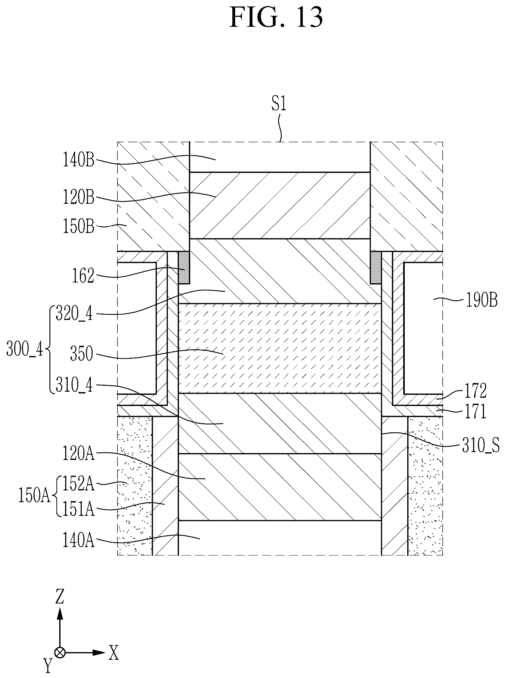

Referring to FIG. 13, the barrier structure 300_4 may further include a dummy barrier pattern 350 positioned between the first barrier pattern 310_4 and the second barrier pattern 320_4.

Dummy barrier pattern 350 may be positioned on top of first barrier pattern 310_4. The dummy barrier pattern 350 may overlap with the upper interlayer insulating layer 190B in the first direction (X direction). The dummy barrier pattern 350 may be spaced apart from the lower source/drain pattern 150A and the upper source/drain pattern 150B in the third direction (Z direction), but example implementations are not limited thereto. The dummy barrier pattern 350 may include a semiconductor material. The dummy barrier pattern 350 may include the same material as the substrate 100, the active pattern 110, the plurality of lower channel patterns 140A, and the plurality of upper channel patterns 140B. For example, the dummy barrier pattern 350 may include silicon (Si). The dummy barrier pattern 350 may be substantially undoped with impurities.

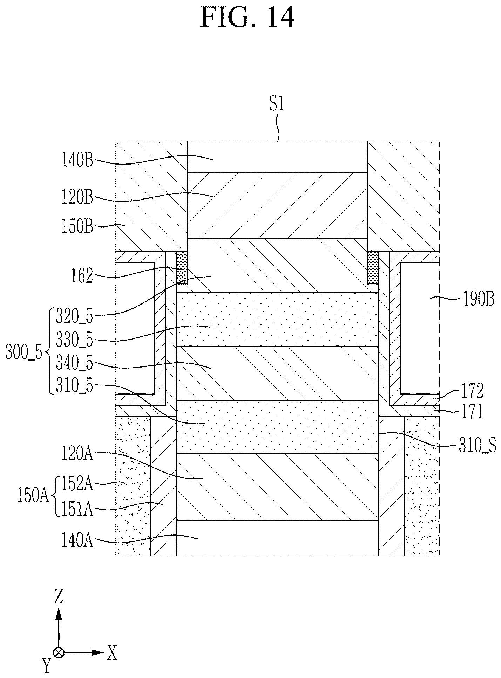

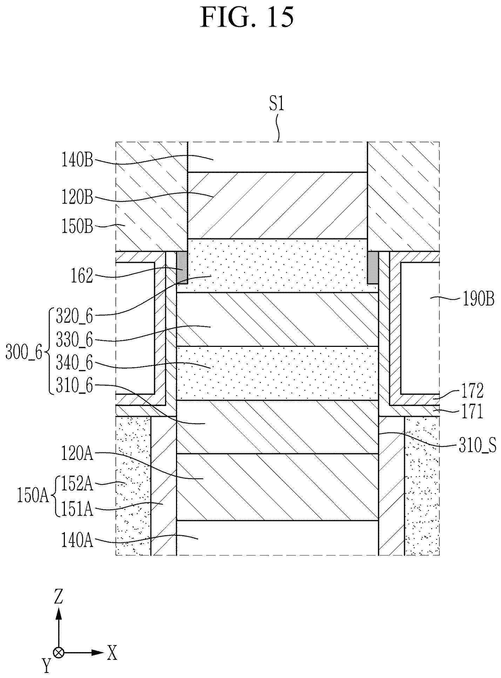

In the implementations of FIG. 14 and FIG. 15, the first barrier pattern 310_5 and the second barrier pattern 320_5 may have different conductivity types. For example, as illustrated in FIG. 14, the lower source/drain pattern 150A may have a first conductivity type, and the first barrier pattern 310_5 may have a second conductivity type different from the first conductivity type. Additionally, the upper source/drain pattern 150B may have a second conductivity type, and the second barrier pattern 320_5 may have a first conductivity type different from the second conductivity type. As another example, as illustrated in FIG. 15, the lower source/drain pattern 150A may have a second conductivity type, and the first barrier pattern 310_6 may have a first conductivity type different from the second conductivity type. Additionally, the upper source/drain pattern 150B may have a first conductivity type, and the second barrier pattern 320_6 may have a second conductivity type different from the first conductivity type.

Referring FIGS. 14 and 15, the barrier structure 300_5, 300_6 of the semiconductor device according to some implementations may further include a third barrier pattern 330_5 and a fourth barrier pattern 340_5 positioned between the first barrier pattern 310_5 and the second barrier pattern 320_5.

The third barrier pattern 330_5 may be positioned on the first barrier pattern 310_5. The third barrier pattern 330_5 may overlap with the upper interlayer insulating layer 190B in the first direction (X direction). The third barrier pattern 330_5 may be spaced apart from the lower source/drain pattern 150A and the upper source/drain pattern 150B in the third direction (Z direction), but example implementations are not limited thereto. The fourth barrier pattern 340_5 may be positioned between the third barrier pattern 330_5 and the first barrier pattern 310_5. The fourth barrier pattern 340_5 may overlap with the upper interlayer insulating layer 190B in the first direction (X direction). The fourth barrier pattern 340_5 may be spaced apart from the lower source/drain pattern 150A and the upper source/drain pattern 150B in the third direction (Z direction), but example implementations are not limited thereto.

The third barrier pattern 330_5 and the fourth barrier pattern 340_5 may have predetermined conductivity types. The third barrier pattern 330_5 may have a different conductivity type than the second barrier pattern 320_5, and the fourth barrier pattern 340_5 may have a different conductivity type than the third barrier pattern 330_5. The fourth barrier pattern 340_5 may have a different conductivity type than the first barrier pattern 310_5, but example implementations are not limited thereto. For example, in the implementation of FIG. 14, if the first barrier pattern 310_5 has the second conductivity type and the second barrier pattern 320_5 has the first conductivity type, the third barrier pattern 330_5 may have the second conductivity type and the fourth barrier pattern 340_5 may have the first conductivity type. Here, the first conductivity type may be P type and the second conductivity type may be N type. Accordingly, the barrier structure 300_5 may form a PN interface between the first barrier pattern 310_5 and the fourth barrier pattern 340_5, between the fourth barrier pattern 340_5 and the third barrier pattern 330_5, and between the third barrier pattern 330_5 and the second barrier pattern 320_5.

As another example, in the implementation of FIG. 15, if the first barrier pattern 310_6 has the first conductivity type and the second barrier pattern 320_6 has the second conductivity type, the third barrier pattern 330_6 may have the first conductivity type and the fourth barrier pattern 340_6 may have the second conductivity type. Here, the first conductivity type may be P type and the second conductivity type may be N type. Accordingly, the barrier structure 300_6 may form a PN interface between the first barrier pattern 310_6 and the fourth barrier pattern 340_6, between the fourth barrier pattern 340_6 and the third barrier pattern 330_6, and between the third barrier pattern 330_6 and the second barrier pattern 320_6.

Referring to FIG. 16, the semiconductor device according to some implementations may further include an intermediate insulating structure 210 positioned between the lower gate electrode 120A and the upper gate electrode 120B.

The intermediate insulating structure 210 may be positioned on the lower gate electrode 120A. The intermediate insulating structure 210 may be positioned between the lower gate electrode 120A and the upper gate electrode 120B. The intermediate insulating structure 210 may overlap the barrier structure 300 in the second direction (Y direction). The lower gate electrode 120A and the upper gate electrode 120B may be separated in the third direction (Z direction) by the intermediate insulating structure 210. The lower gate electrode 120A and the upper gate electrode 120B may not be electrically connected (e.g., may be electrically insulated from each other). The intermediate insulating structure 210 may be spaced apart from the plurality of lower channel patterns 140A and the plurality of upper channel patterns 140B in the third direction (Z direction), but example implementations are not limited thereto.

The upper surface of the intermediate insulating structure 210 may be positioned at substantially the same level as the upper surface of the barrier structure 300. That is, the upper surface of the intermediate insulating structure 210 and the upper surface of the barrier structure 300 may be positioned at substantially the same distance from the upper surface of the substrate 100, but example implementations are not limited thereto. Additionally, the lower surface of the intermediate insulating structure 210 may be positioned at substantially the same level as the lower surface of the barrier structure 300. That is, the lower surface of the intermediate insulating structure 210 and the lower surface of the barrier structure 300 may be positioned at substantially the same distance from the upper surface of the substrate 100, but example implementations are not limited thereto. The intermediate insulating structure 210 may include one or more of various insulating materials. For example, the intermediate insulating structure 210 may include, but example implementations are not limited thereto, silicon oxide, silicon nitride, silicon oxynitride, or combinations thereof.

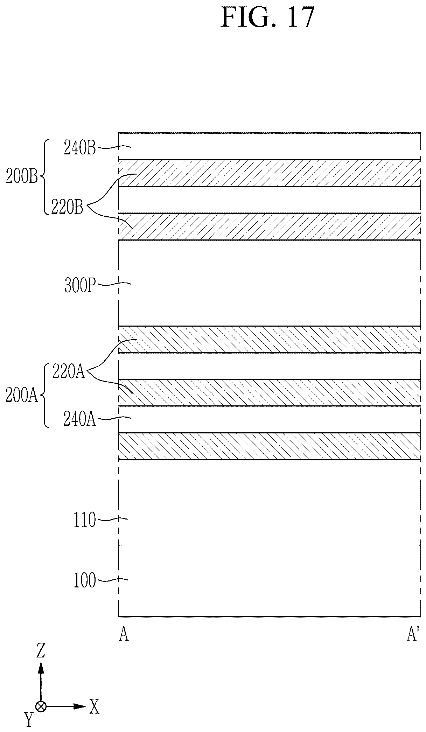

Hereinafter, a method for manufacturing a semiconductor device according to some implementations will be described, referring to FIG. 17 to FIG. 30.

FIGS. 17 to 30 are cross-sectional views showing intermediate stages of a method for manufacturing a semiconductor device according to some implementations.

As shown in FIG. 17, a lower pattern structure 200A including lower sacrificial layers 220A and lower active patterns 240A alternately stacked on a substrate 100, a preliminary barrier structure 300P, and an upper pattern structure 200B including upper sacrificial layers 220B and upper active patterns 240B alternately stacked may be formed.

The substrate 100 may be silicon-on-insulator (SOI) or bulk silicon. Alternatively, the substrate 100 may be a silicon substrate, or may include other materials, such as but not limited to silicon germanium (SiGe), SGOI (silicon germanium on insulator), indium antimonide, lead telluride, indium arsenide, indium phosphide, gallium arsenide or gallium antimonide.

The lower sacrificial layers 220A and the lower active patterns 240A may be alternately laminated (e.g., alternately stacked) along the third direction (Z direction) on the substrate 100. The lower sacrificial layers 220A may be formed of a material having an etch selectivity with respect to the lower active patterns 240A and the preliminary barrier structure 300P. The lower sacrificial layers 220A may comprise a different material from the lower active patterns 240A and the preliminary barrier structure 300P. For example, the lower sacrificial layers 220A may include silicon germanium (SiGe), and the lower active patterns 240A and the preliminary barrier structure 300P may include silicon (Si), but example implementations are not limited thereto.

The preliminary barrier structure 300P may be positioned on the lower pattern structure 200A. The preliminary barrier structure 300P may include a semiconductor material. The preliminary barrier structure 300P may comprise the same material as the substrate 100 and the active pattern 110. The preliminary barrier structure 300P may include the same material as the lower active patterns 240A and the upper active patterns 240B. For example, the preliminary barrier structure 300P may include, but example implementations are not limited thereto, silicon (Si).

The upper sacrificial layers 220B and the upper active patterns 240B may be alternately laminated (e.g., alternately stacked) along the third direction (Z direction) on the preliminary barrier structure 300P. The upper sacrificial layers 220B may be formed of a material having an etch selectivity with respect to the upper active patterns 240B and the preliminary barrier structure 300P. The upper sacrificial layers 220B may include a different material from the upper active patterns 240B and the preliminary barrier structure 300P. For example, the upper sacrificial layers 220B may include silicon germanium (SiGe), and the upper active patterns 240B and the preliminary barrier structure 300P may include silicon (Si), but example implementations are not limited thereto.

The lower pattern structure 200A, the preliminary barrier structure 300P, and the upper pattern structure 200B formed on the substrate 100 may be formed by performing an epitaxial growth process using the substrate 100 as a seed.

In some implementations, the number of lower active patterns 240A alternately stacked with lower sacrificial layers 220A and the number of upper active patterns 240B alternately stacked with upper sacrificial layers 220B may vary in the implementations.

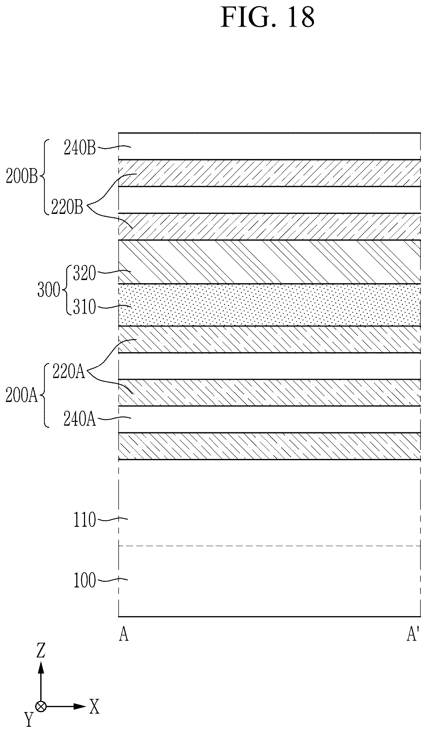

As shown in FIG. 18, an implant process may be performed to form a barrier structure 300 including a first barrier pattern 310 having a second conductive type within a preliminary barrier structure 300P and a second barrier pattern 320 having the first conductive type positioned on the first barrier pattern 310.

For example, a barrier structure 300 may be formed by repeatedly injecting impurities having different conductivity types into a preliminary barrier structure 300P by performing an implant process. Specifically, first, a first barrier pattern 310 having a second conductivity type may be formed within a preliminary barrier structure 300P using an implant process. The first barrier pattern 310 may be formed on the lower side of the preliminary barrier structure 300P. That is, the first barrier pattern 310 may be formed on the preliminary barrier structure 300P portion adjacent to the lower pattern structure 200A. The first barrier pattern 310 may have a second conductivity type. The first barrier pattern 310 may be doped with a second conductivity type impurity. Here, the second conductivity type may be N type. For example, the second barrier pattern 320 may include P, Sb, As, or a combination thereof.

Next, a second barrier pattern 320 having a first conductivity type may be formed within the preliminary barrier structure 300P using an implant process. The second barrier pattern 320 may be formed on the upper side of the preliminary barrier structure 300P. That is, the second barrier pattern 320 may be formed on the portion of the preliminary barrier structure 300P adjacent to the upper pattern structure 200B. The second barrier pattern 320 may be formed on the first barrier pattern 310. The second barrier pattern 320 may have a first conductivity type. The second barrier pattern 320 may be doped with first conductivity type impurities. Here, the first conductivity type may be P type. For example, the second barrier pattern 320 may include B, V, In, Ga, Al, or a combination thereof.

In the process of forming the barrier structure 300, at least a portion of the lower sacrificial layers 220A and/or the upper sacrificial layers 220B may be doped with impurities. For example, in the process of forming the first barrier pattern 310 using an implant process, at least a portion of the lower sacrificial layers 220A may be co-doped with a second conductive type impurity. Alternatively or additionally, during the process of forming the second barrier pattern 320 using an implant process, at least a portion of the upper sacrificial layers 220B may be co-doped with first-conductivity type impurities.

However, example implementations are not limited thereto, and the process of forming the barrier structure 300 may first form the second barrier pattern 320 having the first conductivity type using an implant process, and then forming the first barrier pattern 310 having the second conductivity type. For instance, the order of the formation of the first barrier pattern 310 and the second barrier pattern 320 may be varied. In addition, the doping impurity type(s) of the first barrier pattern 310 and the second barrier pattern 320 may be varied.

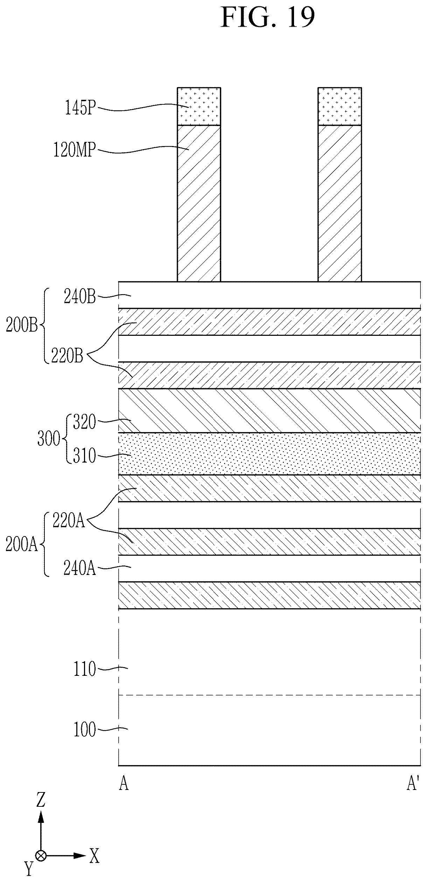

As shown in FIG. 19, a sacrificial gate electrode 120MP and a preliminary capping layer 145P may be formed on the upper pattern structure 200B. The sacrificial gate electrode 120MP may include, but example implementations are not limited thereto, polysilicon. The preliminary capping layer 145P may include, but example implementations are not limited thereto, silicon nitride, for example.

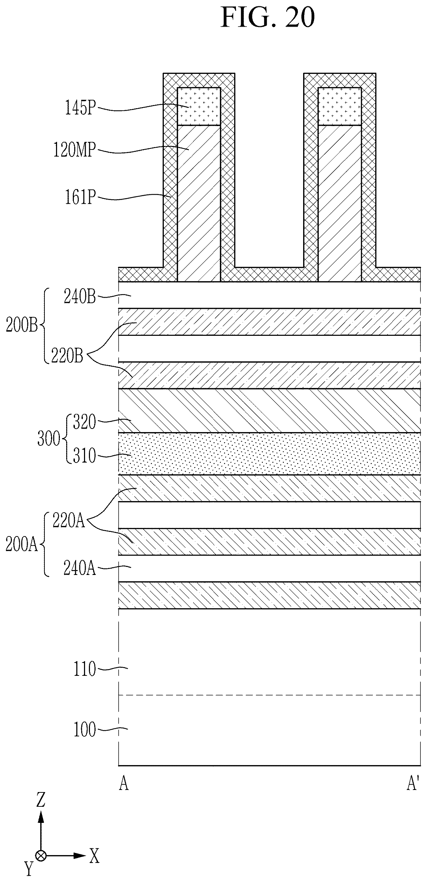

As shown in FIG. 20, a first preliminary gate spacer 161P may be formed on the upper pattern structure 200B and the preliminary capping layer 145P. A first preliminary gate spacer 161P may be formed on the upper surface of the upper pattern structure 200B, the side surface of the sacrificial gate electrode 120MP, the side surface of the preliminary capping layer 145P, and the upper surface of the preliminary capping layer 145P. The first preliminary gate spacer 161P may be conformally formed along the upper surface of the upper pattern structure 200B, the side surface of the sacrificial gate electrode 120MP, the side surface of the preliminary capping layer 145P, and the upper surface of the preliminary capping layer 145P, but example implementations are not limited thereto. The first preliminary gate spacer 161P may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and combinations thereof. The first preliminary gate spacer 161P is shown as a single layer for convenience of explanation only and is not limited thereto.

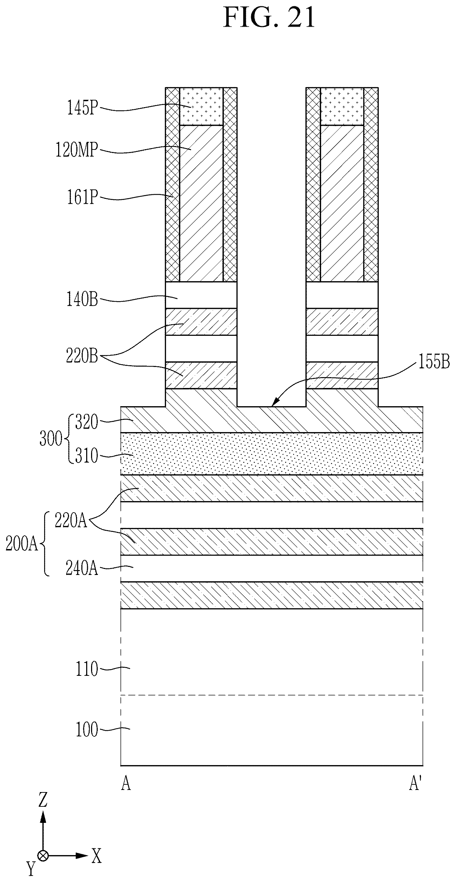

As shown in FIG. 21, the upper pattern structure 200B may be patterned using the first preliminary gate spacer 161P, the preliminary capping layer 145P, and the sacrificial gate electrode 120MP as a mask to form the upper source/drain recess 155B.

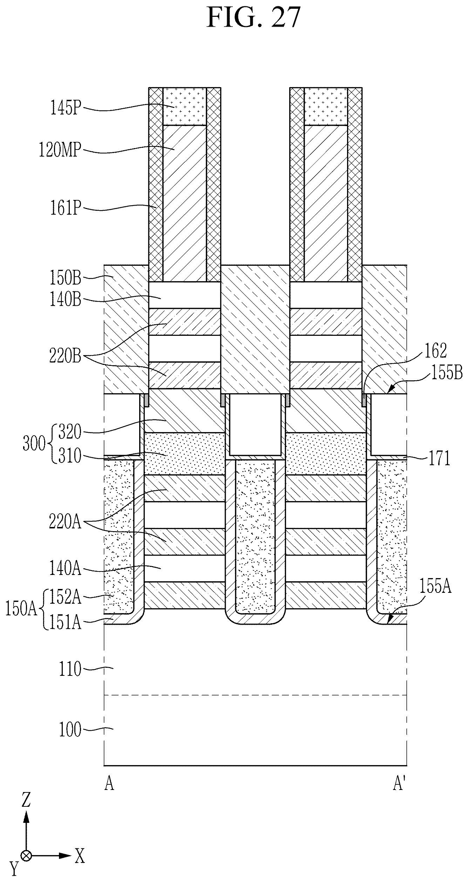

The upper source/drain recess 155B may penetrate the upper pattern structure 200B. The upper source/drain recess 155B may recess a portion of the second barrier pattern 320. In the cross-section formed in the first direction (X direction) and the third direction (Z direction), the width of the lower portion and the width of the upper portion of the upper source/drain recess 155B may be substantially the same, but example implementations are not limited thereto. For example, the upper source/drain recess 155B may have a sloped side surface where the width at the bottom is narrower than the width at the top, depending on the aspect ratio. Here, the upper source/drain recess 155B may mean a region where an upper source/drain pattern (see 150B of FIG. 27) is formed in a subsequent process. In this case, the first preliminary gate spacer 161P positioned on (e.g., on an upper surface of) the preliminary capping layer 145P may be removed together.

As the upper source/drain recess 155B is formed, the upper active patterns 240B may be separated to form the plurality of upper channel patterns 140B. The plurality of upper channel patterns 140B may be positioned on opposite sides of the upper source/drain recess 155B. The inner wall of the upper source/drain recess 155B may be defined by a plurality of upper channel patterns 140B and the plurality of upper sacrificial layers 220B. The bottom surface of the upper source/drain recess 155B may be defined by the second barrier pattern 320. It may have a structure in which the plurality of upper channel patterns 140B and upper sacrificial layers 220B are alternately stacked. In this case, the lengths of the plurality of upper channel patterns 140B in the first direction (X direction) may be the same or different.

As shown in FIG. 22, a second preliminary gate spacer 162P may be formed on the inner sidewall of the upper source/drain recess 155B and the side surface of the first preliminary gate spacer 161P.

For example, a second preliminary gate spacer 162P may be formed on the side surface of the plurality of upper channel patterns 140B exposed by the upper source/drain recess 155B, the side surface of the upper sacrificial layers 220B, and the side surface of the first preliminary gate spacer 161P. The second preliminary gate spacer 162P may be conformally formed on, but example implementations are not limited thereto, the side surfaces of the plurality of upper channel patterns 140B, the side surfaces of the upper sacrificial layers 220B, and the side surfaces of the first preliminary gate spacer 161P. The second preliminary gate spacer 162P may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and combinations thereof. The second preliminary gate spacer 162P is shown as being a single layer, but this is for convenience of explanation only and is not limited thereto.

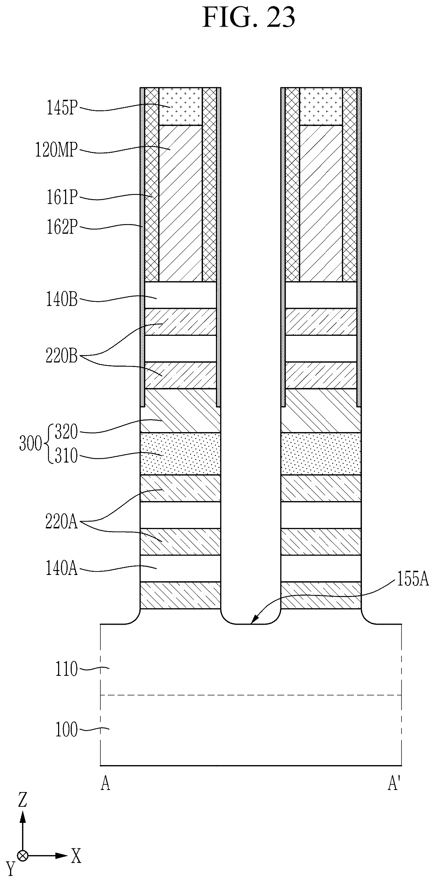

As shown in FIG. 23, the first preliminary gate spacer 161P, the preliminary capping layer 145P, and the sacrificial gate electrode 120MP may be used as masks to pattern the barrier structure 300 and the lower pattern structure 200A to form the lower source/drain recess 155A.

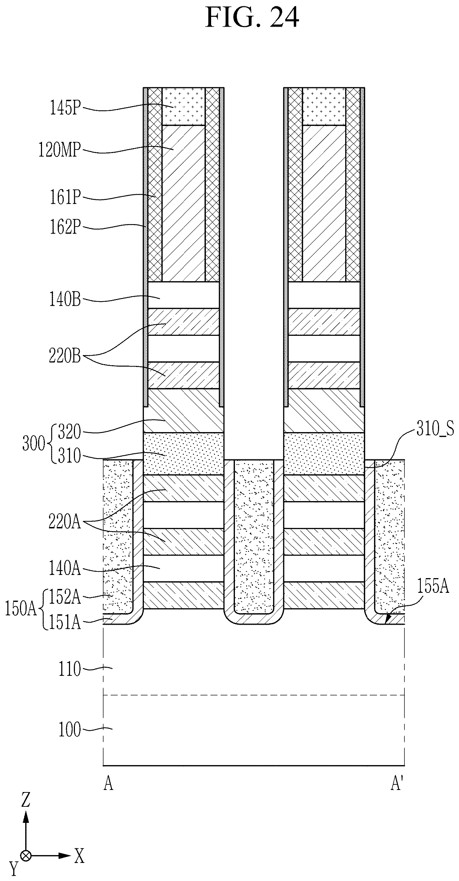

The lower source/drain recess 155A may penetrate the barrier structure 300 and the lower pattern structure 200A. The lower source/drain recess 155A may recess a portion of the active pattern 110. In the cross-section formed in the first direction (X direction) and the third direction (Z direction), the width of the lower portion of the lower source/drain recess 155A may be substantially the same, but example implementations are not limited thereto. For example, the lower source/drain recess 155A may have a sloped side surface where the width at the bottom is narrower than the width at the top, depending on the aspect ratio. Here, the lower source/drain recess 155A may mean a region where a lower source/drain pattern (see 150A of FIG. 24) is formed in a subsequent process.

As the lower source/drain recess 155A is formed, the lower active patterns 240A may be separated to form the plurality of lower channel patterns 140A. The plurality of lower channel patterns 140A may be positioned on opposite sides of the lower source/drain recess 155A. The inner wall of the lower source/drain recess 155A may be defined by a plurality of lower channel patterns 140A and the plurality of lower sacrificial layers 220A. The bottom surface of the lower source/drain recess 155A may be defined by the active pattern 110. It may have a structure in which the plurality of lower channel patterns 140A and lower sacrificial layers 220A are alternately laminated (e.g., alternately stacked). In this case, the lengths of the plurality of lower channel patterns 140A in the first direction (X direction) may be the same or different.

In this case, since the second preliminary gate spacer 162P is positioned on the side surfaces of the plurality of upper channel patterns 140B and the side surfaces of the upper sacrificial layers 220B, the plurality of upper channel patterns 140B and the upper sacrificial layers 220B may not be etched during the process of forming the lower source/drain recess 155A.

As shown in FIG. 24, a lower source/drain pattern 150A may be formed within the lower source/drain recess 155A.

The lower source/drain pattern 150A may fill the lower source/drain recess 155A. First, a first lower source/drain layer 151A may be formed along the inner wall and lower surface of the lower source/drain recess 155A. Next, a second lower source/drain layer 152A may be formed to fill the lower source/drain recess 155A.

The lower source/drain pattern 150A may be formed using a selective epitaxial growth process using the active pattern 110, the plurality of lower channel patterns 140A, and the first barrier pattern 310 as seeds. In some implementations, the first lower source/drain layer 151A may be grown on the side surface of the first barrier pattern 310 as the first barrier pattern 310 includes silicon (Si).

At least a portion of the lower source/drain pattern 150A may overlap the barrier structure 300 in the first direction (X direction). For example, at least a portion of the lower source/drain pattern 150A may overlap with the first barrier pattern 310 in the first direction (X direction). At least a portion of the lower source/drain pattern 150A may be in contact with the first barrier pattern 310. The upper surface of the lower source/drain pattern 150A may be positioned at a higher level than the lower surface of the first barrier pattern 310. The upper surface of the lower source/drain pattern 150A may be positioned farther from the upper surface of the substrate 100 than the lower surface of the first barrier pattern 310. A distance between the lower surface of the first barrier pattern 310 and the upper surface of the substrate 100 may be less than a distance between the upper surface of the lower source/drain pattern 150A and the upper surface of the substrate 100. A distance between the upper surface of the first barrier pattern 310 and the upper surface of the substrate 100 may be longer than a distance between the upper surface of the lower source/drain pattern 150A and the upper surface of the substrate 100.

The lower source/drain pattern 150A may have a predetermined conductivity type. The lower source/drain pattern 150A may have a different conductivity type than the first barrier pattern 310. For example, the lower source/drain pattern 150A may have a first conductivity type. The lower semiconductor pattern 150A may be doped with first conductivity type impurities. Here, the first conductivity type may be P type, but example implementations are not limited thereto. For example, the lower source/drain pattern 150A may include B, V, In, Ga, Al, or a combination thereof. In some implementations, the doping concentration of the impurities in the first barrier pattern 310 may be less than or equal to the doping concentration of the impurities in the lower source/drain pattern 150A. The doping concentration of the impurity of the first barrier pattern 310 may be less than or equal to the doping concentration of the impurity of the plurality of lower channel patterns 140A. In this range, the first barrier pattern 310 may prevent leakage current from occurring between the lower source/drain pattern 150A positioned on opposite sides along the first direction (X direction) of the lower sacrificial layers 220A.

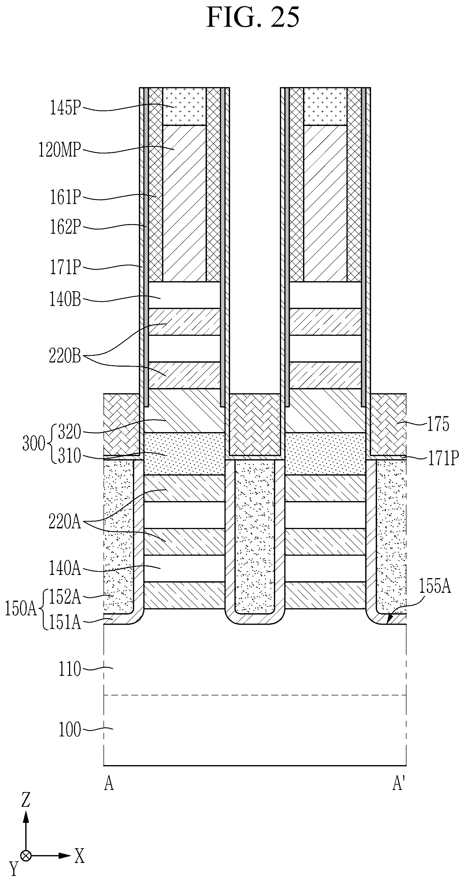

As shown in FIG. 25, a first preliminary liner film 171P may be formed on the upper surface of the lower source/drain pattern 150A, the side surface of the barrier structure 300, and the side surface of the second preliminary gate spacer 162P, and an intermediate insulating layer 175 may be formed on the first preliminary liner film 171P.

The first preliminary liner film 171P may surround at least a portion of the lower source/drain pattern 150A. For example, the first preliminary liner film 171P may be positioned on opposite side surfaces (e.g., in the second direction) and the upper surface of the lower source/drain pattern 150A. First, the first preliminary liner film 171P may contain one or more of various insulating materials. For example, the first preliminary liner film 171P may include at least one of silicon nitride (SiN), silicon oxynitride (SiON), silicon oxycarbonitride (SiOCN), silicon boron nitride (SiBN), silicon oxyboron nitride (SiOBN), silicon oxycarbide (SiOC), and combinations thereof.

The intermediate insulating layer 175 may be positioned on the first preliminary liner film 171P. The upper surface of the intermediate insulating layer 175 may be positioned at substantially the same level as the upper surface of the barrier structure 300, but example implementations are not limited thereto. The upper surface of the intermediate insulating layer 175 and the upper surface of the barrier structure 300 and may be positioned at substantially the same distance from the upper surface of the substrate 100, but example implementations are not limited thereto.

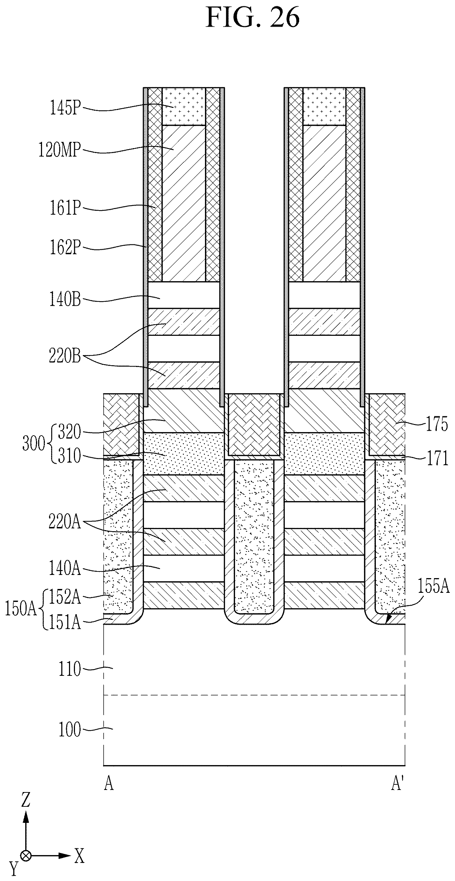

As shown in FIG. 26, the first preliminary liner film 171P may be patterned to form the first liner film 171. At least a portion of the first preliminary liner film 171P may be etched using an etchant or etching gas having an etch selectivity with respect to the intermediate insulating layer 175. Accordingly, the first preliminary liner film 171P portion covered by the intermediate insulating layer 175 may not be etched.

As shown in FIG. 27, after etching at least a portion of the second preliminary gate spacer 162P to form the second gate spacer 162, an upper source/drain pattern 150B may be formed within the upper source/drain recess 155B.

First, at least a portion of the second preliminary gate spacer 162P may be etched using an etchant or etching gas having an etch selectivity with respect to the intermediate insulating layer 175. Accordingly, the portion of the second preliminary gate spacer 162P covered by the intermediate insulating layer 175 and the first liner film 171 may not be etched. Accordingly, a second gate spacer 162 may be formed. The second gate spacer 162 may overlap the barrier structure 300 in the first direction (X direction). Accordingly, the side surfaces of the plurality of upper channel patterns 140B and the side surfaces of the upper sacrificial layers 220B may be exposed.

Next, the intermediate insulating layer 175 may be removed through a cleaning process. Accordingly, the first liner film 171 may be exposed.

Next, an upper source/drain pattern 150B may be formed within the upper source/drain recess 155B. The upper source/drain pattern 150B may fill the upper source/drain recess 155B. The upper source/drain pattern 150B may be formed using a selective epitaxial growth process using the plurality of upper channel patterns 140B as seeds.

The upper source/drain pattern 150B may be positioned on the lower source/drain pattern 150A. The upper source/drain pattern 150B may be spaced apart from the lower source/drain pattern 150A in the third direction (Z direction).

The width along the first direction (X direction) of the upper source/drain pattern 150B may be greater than the width along the first direction (X direction) of the lower source/drain pattern 150A. This may be due to the process characteristics of forming the upper source/drain recess 155B, forming the second preliminary gate spacer (see 162P of FIG. 22) within the upper source/drain recess 155B, and then forming the lower source/drain recess 155A. However, example implementations are not limited thereto, and the width along the first direction (X direction) of the upper source/drain pattern 150B may be smaller than or equal to the width along the first direction (X direction) of the lower source/drain pattern 150A.

At least a portion of the upper source/drain pattern 150B may overlap with the barrier structure 300 in the first direction (X direction). For example, at least a portion of the upper source/drain pattern 150B may overlap the second barrier pattern 320 in the first direction (X direction). At least a portion of the upper source/drain pattern 150B may be in contact with the second barrier pattern 320.

The upper source/drain pattern 150B may have a predetermined conductivity type. The upper source/drain pattern 150B may have a different conductivity type than the second barrier pattern 320. For example, the upper source/drain pattern 150B may have a second conductivity type that is different from the first conductivity type. The upper source/drain pattern 150B may be doped with second conductivity type impurities. Here, the second conductivity type may be N type. For example, the upper source/drain pattern 150B may include P, Sb, As, or a combination thereof. The upper source/drain pattern 150B may have a different conductivity type than the lower source/drain pattern 150A, but example implementations are not limited thereto, and the upper source/drain pattern 150B may also have a different conductivity type than the lower source/drain pattern 150A.

The doping concentration of the impurity in the upper source/drain pattern 150B may be greater than or equal to the doping concentration of the impurity in the second barrier pattern 320. The doping concentration of the impurity of the second barrier pattern 320 may be less than or equal to the doping concentration of the impurity of the plurality of upper channel patterns 140B. In this range, the second barrier pattern 320 may prevent leakage current from occurring between the upper source/drain pattern 150B positioned on opposite sides along the first direction (X direction) of the upper gate electrode 120B.

In some implementations, the upper source/drain pattern 150B is described as being formed of a single layer, but example implementations are not limited thereto, and the upper source/drain pattern 150B may be formed of the plurality of layers including semiconductor materials.

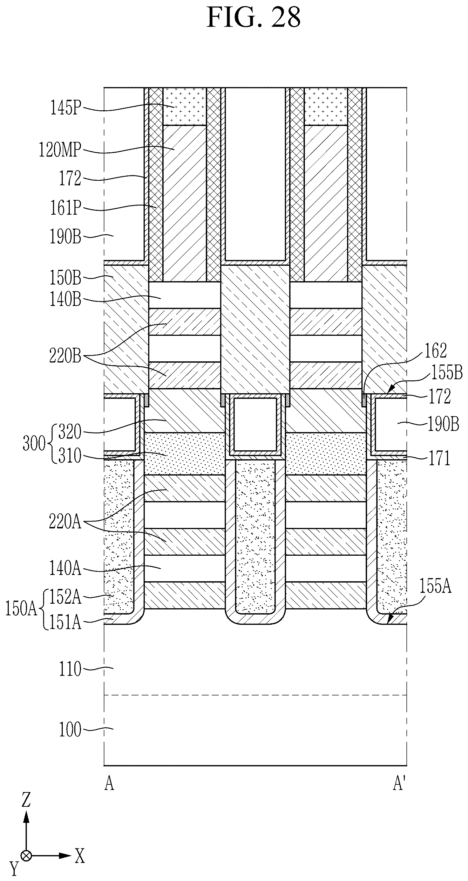

Referring to FIG. 28, a second liner film 172 surrounding the upper source/drain pattern 150B may be formed, and an upper interlayer insulating layer 190B may be formed on the second liner film 172.

The second liner film 172 may surround at least a portion of the upper source/drain pattern 150B. For example, the second liner film 172 may be positioned on the lower surface, opposite side surfaces (e.g., in the second direction), and the upper surface of the upper source/drain pattern 150B. The second liner film 172 may completely surround the upper source/drain pattern 150B. The second liner film 172 may contain one or more of various insulating materials. The second liner film 172 may contain the same material as the first liner film 171. The second liner film 172 may include, but example implementations are not limited thereto, a different material than the upper interlayer insulating layer 190B. For example, the second liner film 172 may include at least one of silicon nitride (SiN), silicon oxynitride (SiON), silicon oxycarbonitride (SiOCN), silicon boron nitride (SiBN), silicon oxyboron nitride (SiOBN), silicon oxycarbide (SiOC), and combinations thereof.

The upper interlayer insulating layer 190B may be positioned on the second liner film 172. The upper interlayer insulating layer 190B may surround at least a portion of the upper source/drain pattern 150B. For example, the upper interlayer insulating layer 190B may be positioned on the lower surface, side surface (e.g., in the second direction), and upper surface of the upper source/drain pattern 150B. The upper interlayer insulating layer 190B may completely surround the upper source/drain pattern 150B, but example implementations are not limited thereto. The upper interlayer insulating layer 190B may be positioned between the upper source/drain pattern 150B and the lower source/drain pattern 150A. Additionally, the upper interlayer insulating layer 190B may be positioned on the side surface of the first gate spacer 161 and the side surface of the preliminary capping layer 145P (e.g., in the first direction). The upper interlayer insulating layer 190B may include one or more of various insulating materials. The upper interlayer insulation layer 190B may include, but example implementations are not limited thereto, the same material as the lower interlayer insulation layer 190A.

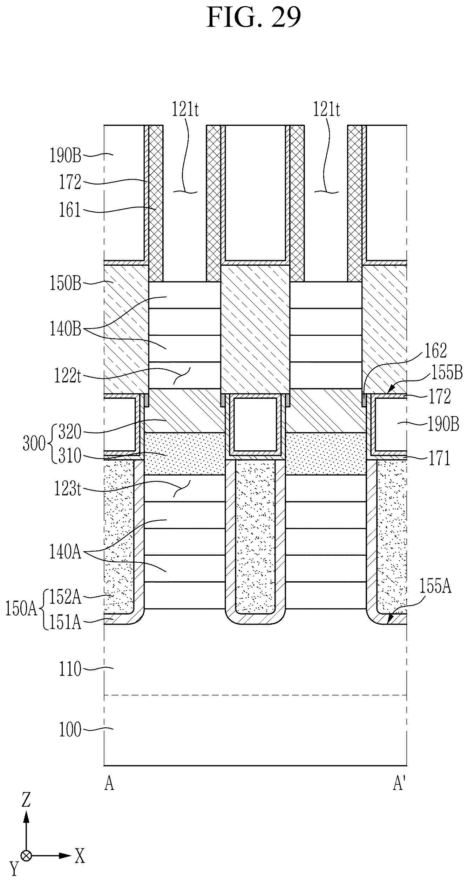

As shown in FIG. 29, the preliminary capping layer 145P may be removed, the sacrificial gate electrode 120MP may be removed to form a first gate trench 121t, the upper sacrificial layers 220B may be removed to form a second gate trench 122t, and the lower sacrificial layers 220A may be removed to form a third gate trench 123t. In the process of removing the preliminary capping layer 145P, at least a portion of the first preliminary gate spacer 161P may be removed together to form the first gate spacer 161.

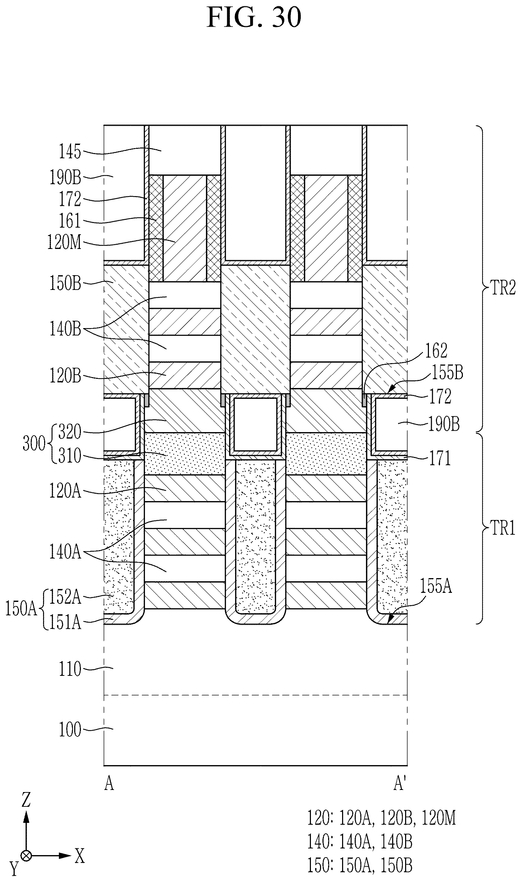

As shown in FIG. 30, a semiconductor device according to some implementations may be formed by forming a lower gate electrode 120A in the third gate trench 123t, forming an upper gate electrode 120B in the second gate trench 122t, and forming a main gate electrode 120M in the first gate trench 121t. Subsequently, a capping layer 145 may be formed on the main gate electrode 120M and on the first gate spacer 161. In one embodiment, upper portions of the main gate electrode 120M and the first gate spacer 161 may be etched before the capping layer 145 is deposited thereon, between the upper portions of the upper interlayer insulation layer 190B.

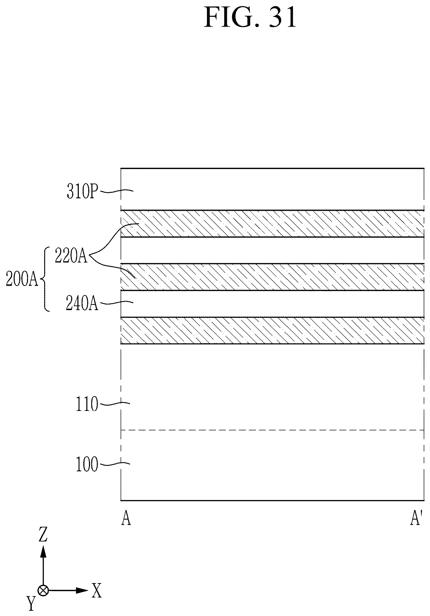

Hereinafter, a method for manufacturing a semiconductor device according to some implementations will be described, with reference to FIG. 31 to FIG. 35.

FIGS. 31 to 35 are cross-sectional views showing intermediate steps in a method of manufacturing a semiconductor device according to some implementations.

The implementations illustrated in FIG. 31 to FIG. 35 are similar to the implementations illustrated in FIG. 17 to FIG. 30, so a description thereof will be omitted and the differences will be mainly explained.

As shown in FIG. 31, a lower pattern structure 200A including lower sacrificial layers 220A and lower active patterns 240A alternately stacked on a substrate 100 and a first preliminary barrier pattern 310P may be formed on the lower pattern structure 200A.

The substrate 100 may be silicon-on-insulator (SOI) or bulk silicon. Alternatively, the substrate 100 may be a silicon substrate, or may include other materials, such as but not limited to silicon germanium (SiGe), SGOI (silicon germanium on insulator), indium antimonide, lead telluride, indium arsenide, indium phosphide, gallium arsenide or gallium antimonide.

The lower sacrificial layers 220A and the lower active patterns 240A may be alternately laminated (e.g., alternatively stacked) along the third direction (Z direction) on the substrate 100. The lower sacrificial layers 220A may be formed of a material having an etch selectivity with respect to the lower active patterns 240A and the first preliminary barrier pattern 310P. The lower sacrificial layers 220A may include a different material from the lower active patterns 240A and the first preliminary barrier pattern 310P. For example, the lower sacrificial layers 220A may include silicon germanium (SiGe), and the lower active patterns 240A and the first preliminary barrier pattern 310P may include silicon (Si), but example implementations are not limited thereto.

The first preliminary barrier pattern 310P may be positioned on the lower pattern structure 200A. The first preliminary barrier pattern 310P may include a semiconductor material. The first preliminary barrier pattern 310P may include the same material as the substrate 100 and the active pattern 110. The first preliminary barrier pattern 310P may contain the same material as the lower active patterns 240A. For example, the first preliminary barrier pattern 310P may include, but example implementations are not limited thereto, silicon (Si). The first preliminary barrier pattern 310P may refer to an area where the first barrier pattern 310 is formed in a subsequent process.

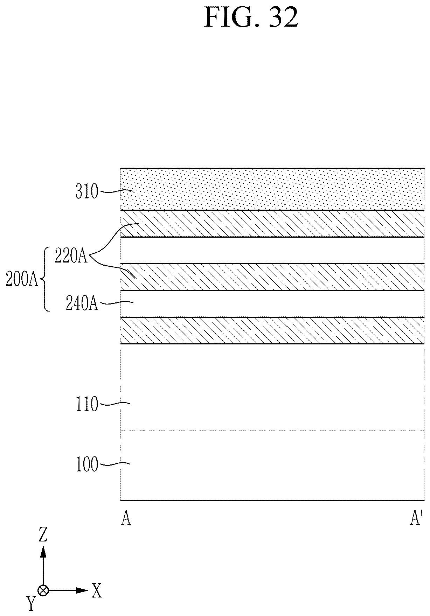

As shown in FIG. 32, a first barrier pattern 310 having a second conductivity type may be formed within a first preliminary barrier pattern 310P using an implant process. The first barrier pattern 310 may have a second conductivity type. The first barrier pattern 310 may be doped with a second conductivity type impurity. Here, the second conductivity type may be N type. For example, the first barrier pattern 310 may include P, Sb, As, or a combination thereof.

In some implementations, during the process of forming the first barrier pattern 310 using an implant process, at least a portion of the lower sacrificial layers 220A may be co-doped with a second conductive type impurity.

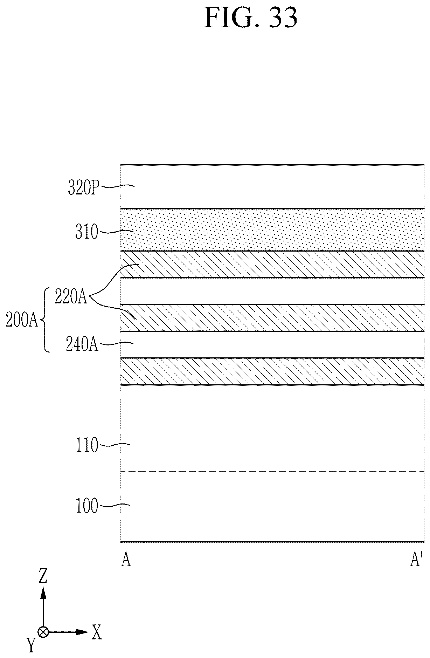

As shown in FIG. 33, a second preliminary barrier pattern 320P may be formed on the first barrier pattern 310. The second preliminary barrier pattern 320P may be formed by performing an epitaxial growth process using the first barrier pattern 310 as a seed. The second preliminary barrier pattern 320P may include a semiconductor material. The second preliminary barrier pattern 320P may include the same material as the substrate 100 and the active pattern 110. The second preliminary barrier pattern 320P may contain the same material as the lower active patterns 240A. For example, the second preliminary barrier pattern 320P may include, but example implementations are not limited thereto, silicon (Si). The second preliminary barrier pattern 320P may refer to an area where the second barrier pattern 320 is formed in a subsequent process.

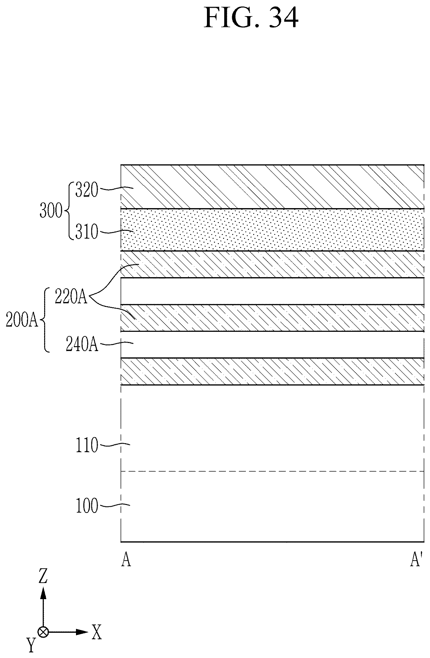

As shown in FIG. 34, a second barrier pattern 320 having a first conductivity type may be formed within a second preliminary barrier pattern 320P using an implant process. The second barrier pattern 320 may have a first conductivity type. The second barrier pattern 320 may be doped with first conductivity type impurities. Here, the first conductivity type may be P type. For example, the second barrier pattern 320 may include B, V, In, Ga, Al, or a combination thereof.

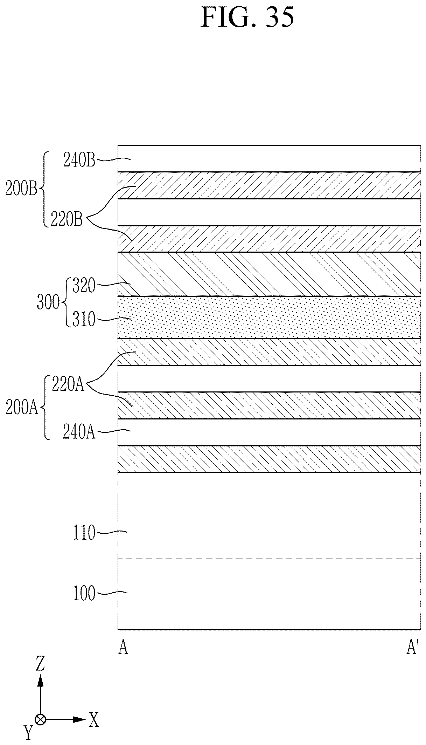

As shown in FIG. 35, an upper pattern structure 200B including an upper sacrificial layers 220B and an upper active patterns 240B alternately stacked on a second barrier pattern 320 may be formed. The upper sacrificial layers 220B and the upper active patterns 240B may be alternately stacked along the third direction (Z direction) over the second barrier pattern 320. The upper sacrificial layers 220B may be formed of a material having an etch selectivity with respect to the upper active patterns 240B and the barrier structure 300. The upper sacrificial layers 220B may include a different material from the upper active patterns 240B and the barrier structure 300. For example, the upper sacrificial layers 220B may include silicon germanium (SiGe), and the upper active patterns 240B may include silicon (Si), but example implementations are not limited thereto.

Next, the processes of FIG. 19 to FIG. 30 may be performed to form a semiconductor device according to some implementations.

Embodiments are set out in the following Clauses:
Clause 1. A semiconductor device comprising:
   a substrate;
   a plurality of lower channel patterns on the substrate;
   a plurality of upper channel patterns on the plurality of lower channel patterns;
   a lower gate electrode between adjacent lower channel patterns of the plurality of lower channel patterns and above and below the plurality of lower channel patterns;
   an upper gate electrode between adjacent upper channel patterns of the plurality of upper channel patterns and above and below the plurality of upper channel patterns;
   a lower source/drain pattern on opposite sides, along a first direction, of each lower channel pattern of the plurality of lower channel patterns;
   an upper source/drain pattern on the lower source/drain pattern and on opposite sides, along the first direction, of each upper channel pattern of the plurality of upper channel patterns; and
   a barrier structure comprising:
   a first barrier pattern on the plurality of lower channel patterns, the first barrier pattern having a conductivity type that is different from a conductivity type of the lower source/drain pattern, and
   a second barrier pattern between the first barrier pattern and the plurality of upper channel patterns, the second barrier pattern having a conductivity type that is different from a conductivity type of the upper source/drain pattern.
Clause 2. The semiconductor device of Clause 1,
   wherein a doping concentration of the first barrier pattern is less than or equal to a doping concentration of the lower source/drain pattern.
Clause 3. The semiconductor device of Clause 1 or Clause 2,
   wherein the doping concentration of the second barrier pattern is less than or equal to a doping concentration of the upper source/drain pattern.
Clause 4. The semiconductor device of any preceding Clause,
   wherein the barrier structure comprises a same material as the plurality of lower channel patterns.
Clause 5. The semiconductor device of Clause 4,
   wherein both the barrier structure and the plurality of lower channel patterns comprise silicon.
Clause 6. The semiconductor device of any preceding Clause,
   wherein the second barrier pattern has a conductivity type that is different from a conductivity type of the first barrier pattern.
Clause 7. The semiconductor device of any preceding Clause,
   wherein a thickness of the first barrier pattern is different from a thickness of the second barrier pattern.
Clause 8. The semiconductor device of any preceding Clause,
   wherein at least a portion of the first barrier pattern overlaps the lower source/drain pattern.
Clause 9. The semiconductor device of Clause 8,
   wherein at least a portion of the second barrier pattern overlaps the upper source/drain pattern.
Clause 10. The semiconductor device of any preceding Clause, comprising:
   an upper interlayer insulating layer between the lower source/drain pattern and the upper source/drain pattern, and
   wherien the upper interlayer insulating layer overlaps the barrier structure.
Clause 11. The semiconductor device of any preceding Clause,
   wherein the barrier structure comprises a third barrier pattern between the first barrier pattern and the second barrier pattern, and
   wherein the third barrier pattern has a conductivity type that is different from a conductivity type of the first barrier pattern.
Clause 12. The semiconductor device of any preceding Clause,
   wherein a distance between a lower surface of the first barrier pattern and an upper surface of the substrate, along a second direction that is perpendicular to the first direction, is less than a distance between an upper surface of the lower source/drain pattern and the upper surface of the substrate, along the second direction.
Clause 13. The semiconductor device of any preceding Clause,
   wherein the lower source/drain pattern comprises:
   a first lower source/drain layer on a side surface, along the first direction, of each lower channel pattern of the plurality of lower channel patterns, and
   a second lower source/drain layer on the first lower source/drain layer, and
   wherein at least a portion of a side surface along the first direction of the first barrier pattern is in contact with the first lower source/drain layer.
Clause 14. The semiconductor device of Clause 13,
   wherein the second lower source/drain layer is spaced apart from the barrier structure.
Clause 15. The semiconductor device of any preceding Clause, comprising:
   an intermediate insulating structure between the lower gate electrode and the upper gate electrode,
   wherein the intermediate insulating structure overlaps the barrier structure.
Clause 16. A semiconductor device comprising:
   a substrate;
   a plurality of lower channel patterns on the substrate;
   a lower gate electrode between adjacent lower channel patterns of the plurality of lower channel patterns and above and below the plurality of lower channel patterns;
   a lower source/drain pattern on opposite sides, along a first direction, of each lower channel pattern of the plurality of lower channel patterns, the lower source/drain pattern having a first conductivity type; and
   a barrier structure on the lower gate electrode,
   the barrier structure comprising
      a first barrier pattern overlapping the lower source/drain pattern, the first barrier pattern having a second conductivity type that is different from the first conductivity type, and
      a second barrier pattern on the first barrier pattern, the second barrier pattern having the first conductivity type.
Clause 17. The semiconductor device of Clause 16,
   wherein a doping concentration of the first barrier pattern is less than or equal to a doping concentration of the lower source/drain pattern.
Clause 18. The semiconductor device of Clause 16 or Clause 17, comprising:
   a plurality of upper channel patterns on the barrier structure;
   an upper gate electrode between adjacent upper channel patterns of the plurality of upper channel patterns; and
   an upper source/drain pattern on opposite sides, along the first direction, of the plurality of upper channel patterns, wherien the upper source/drain pattern has the second conductive type.
Clause 19. A semiconductor device comprising:
   a substrate;
   a plurality of lower channel patterns on the substrate;
   a plurality of upper channel patterns on the plurality of lower channel patterns;
   a lower gate electrode between adjacent lower channel patterns of the plurality of lower channel patterns and above and below the plurality of lower channel patterns;
   an upper gate electrode between adjacent upper channel patterns of the plurality of upper channel patterns and above and below the plurality of upper channel patterns;
   a lower source/drain pattern on opposite sides, along a first direction, of each lower channel pattern of the plurality of lower channel patterns;
   an upper source/drain pattern on the lower source/drain pattern and on opposite sides, along the first direction, of each upper channel pattern of the plurality of upper channel patterns; and
   a barrier structure on the plurality of lower channel patterns and including a same material as the plurality of lower channel patterns,
   wherien the barrier structure comprises
      a first barrier pattern on the lower gate electrode, wherein the first barrier pattern has a conductivity type that is different from a conductivity type of the lower source/drain pattern, and
      a second barrier pattern between the first barrier pattern and the upper gate electrode, wherein the second barrier pattern has a conductivity type that is different from a conductivity type of the upper source/drain pattern,
   wherein a distance between a lower surface of the first barrier pattern and an upper surface of the substrate, along a second direction that is perpendicular to the first direction, is less than a distance between an upper surface of the lower source/drain pattern and the upper surface of the substrate along the second direction.
Clause 20. The semiconductor device of Clause 19,
   wherein a width of the upper source/drain pattern is greater than a width of the lower source/drain pattern.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Although the implementations have been described in detail above, the scope of the present disclosure is not limited thereto, and various modifications and improvements made by those skilled in the art using the basic concept of the present disclosure defined in the following claims also fall within the scope of the present disclosure.

## Claims

1. A semiconductor device comprising:
a substrate (100);
a plurality of lower channel patterns (140A) on the substrate (100);
a plurality of upper channel patterns (140B) on the plurality of lower channel patterns (140A);
a lower gate electrode (120A) between adjacent lower channel patterns of the plurality of lower channel patterns (140A) and above and below the plurality of lower channel patterns (140A);
an upper gate electrode (120B) between adjacent upper channel patterns of the plurality of upper channel patterns (140B) and above and below the plurality of upper channel patterns (140B);
a lower source/drain pattern (150A) on opposite sides, along a first direction, of each lower channel pattern of the plurality of lower channel patterns (140A);
an upper source/drain pattern (150B) on the lower source/drain pattern (150A) and on opposite sides, along the first direction, of each upper channel pattern of the plurality of upper channel patterns (140B); and
a barrier structure (300) comprising:
a first barrier pattern (310) on the plurality of lower channel patterns (140A), the first barrier pattern (310) having a conductivity type that is different from a conductivity type of the lower source/drain pattern (150A), and
a second barrier pattern (320) between the first barrier pattern (310) and the plurality of upper channel patterns (140B), the second barrier pattern (320) having a conductivity type that is different from a conductivity type of the upper source/drain pattern (150B).

2. The semiconductor device of claim 1,
wherein a doping concentration of the first barrier pattern (310) is less than or equal to a doping concentration of the lower source/drain pattern (150A).

3. The semiconductor device of claim 1 of claim 2,
wherein a doping concentration of the second barrier pattern (320) is less than or equal to a doping concentration of the upper source/drain pattern (150B).

4. The semiconductor device of any preceding claim,
wherein the barrier structure (300) comprises a same material as the plurality of lower channel patterns (140A).

5. The semiconductor device of claim 4,
wherein both the barrier structure (300) and the plurality of lower channel patterns (140A) comprise silicon.

6. The semiconductor device of any preceding claim,
wherein the second barrier pattern (320) has a conductivity type that is different from a conductivity type of the first barrier pattern (310).

7. The semiconductor device of any preceding claim,
wherein a thickness of the first barrier pattern (310) is different from a thickness of the second barrier pattern (320).

8. The semiconductor device of any preceding claim,
wherein at least a portion of the first barrier pattern (310) overlaps the lower source/drain pattern (150A).

9. The semiconductor device of any preceding claim,
wherein at least a portion of the second barrier pattern (320) overlaps the upper source/drain pattern (150B).

10. The semiconductor device of any preceding claim, comprising:
an upper interlayer insulating layer (190B) between the lower source/drain pattern (150A) and the upper source/drain pattern (150B), and
wherien the upper interlayer insulating layer (190B) overlaps the barrier structure (300).

11. The semiconductor device of any preceding claim,
wherein the barrier structure (300) comprises a third barrier pattern (330) between the first barrier pattern (310) and the second barrier pattern (320), and
wherein the third barrier pattern (330) has a conductivity type that is different from the conductivity type of the first barrier pattern (310).

12. The semiconductor device of any preceding claim,
wherein a distance between a lower surface of the first barrier pattern (310) and an upper surface of the substrate (100), along a second direction intersecting the first direction, is less than a distance between an upper surface of the lower source/drain pattern (150A) and the upper surface of the substrate (100), along the second direction.

13. The semiconductor device of any preceding claim,
wherein the lower source/drain pattern (150A) comprises:
a first lower source/drain layer (151A) on a side surface, along the first direction, of each lower channel pattern of the plurality of lower channel patterns (140A), and
a second lower source/drain layer (152A) on the first lower source/drain layer (151A), and
wherein at least a portion of a side surface along the first direction of the first barrier pattern (310) is in contact with the first lower source/drain layer (151A).

14. The semiconductor device of claim 13,
wherein the second lower source/drain layer (152A) is spaced apart from the barrier structure (300).

15. The semiconductor device of any preceding claim, comprising:
an intermediate insulating structure (210) between the lower gate electrode (120A) and the upper gate electrode (120B),
wherein the intermediate insulating structure overlaps the barrier structure (300).
